# EUROPEAN PATENT APPLICATION

(11) **EP 4 477 458 A1**
(43) Date of publication of application: **18.12.2024**
(21) Application number: 23753112.4
(22) Date of filing: 07.02.2023
(51) Int. Cl.: B60L 53/35, B60L 3/00, B60L 53/68, B60L 53/66, B60W 30/08, B60W 60/00, B60W 40/02, B60W 30/14, B60W 40/105, B25J 9/16

(54) **DIGITAL TWIN-BASED CHARGING STATION CONTROL SYSTEM**

(30) Priority: 11.02.2022 KR 20220018278
(71) Applicant: LG Electronics Inc., Yeongdeungpo-gu Seoul 07336 (KR)
(72) Inventor: KIM, Sangheon, Seoul 06772 (KR); LEEM, Chaehwan, Seoul 06772 (KR); LEE, Jooyoung, Seoul 06772 (KR); YUN, Taehui, Seoul 06772 (KR); MOON, Sungmock, Seoul 06772 (KR); LEE, Jongmyeong, Seoul 06772 (KR); HONG, Pyonho, Seoul 06772 (KR)
(74) Representative: Vossius & Partner Patentanwälte Rechtsanwälte mbB
(86) International application number: PCT/KR2023/001724
(87) International publication number: WO 2023/153764

(57) **Abstract**

The present invention provides a digital twin-based charging station control system. A device for controlling a vehicle according to an embodiment of the present invention comprises: a communication unit that is communicatively connected to a server provided in a charging station, and receives a digital twin formed to reflect a real-time situation corresponding to the charging station, on the basis of entering the charging station; a display unit that displays the digital twin and receives a user input applied to the digital twin; and a processor that controls the display unit so as to output a first path to a charger in the charging station capable of performing charging, and to display, on the digital twin, a second path to an exit of the charging station when charging has stopped.

## Description

### Technical Field

The present disclosure relates to a digital twin-based charging station control system, and more particularly, to a charging station control system capable of controlling situations that occur in an electric vehicle charging station through a digital twin and including a charging control server and a vehicle.

### Background Art

A vehicle is an apparatus that moves in a direction desired by a user riding therein. A representative example of a vehicle may be an automobile.

Meanwhile, for convenience of a user using a vehicle, various types of sensors and electronic apparatuses are provided in the vehicle. In particular, for the convenience of the user's driving, research on an advanced driver assistance system (ADAS) is being actively carried out. In addition, an autonomous vehicle is actively under development.

Recently, along with development of autonomous driving, use of electric vehicles that employ electric energy charged by an electric source as a power source is increasing.

Since many charging stations for supplying electric energy to charge such electric vehicles are being installed, there is a need for a system capable of controlling all actions that occur in the charging stations.

### Disclosure of Invention

### Technical Problem

Therefore, to obviate those problems, an aspect of the detailed description is to provide a charging station control system capable of controlling and managing actions that occur in the charging station.

An aspect of the detailed description is also to provide a charging station control system capable of controlling events that occur in a charging station and providing optimized functions to a vehicle using a digital twin.

### Solution to Problem

To achieve these and other advantages and in accordance with the purpose of the present disclosure, as embodied and broadly described herein, there is provided a digital twin-based charging control system according to an embodiment of the present disclosure may include a charger installed in a charging station, a charging control server, and a vehicle.

A digital twin-based charging control method according to an embodiment of the present invention may include: generating a virtual space which is a three-dimensional virtual space obtained by combining information of a real world with a digital world, based on information of a charging station in which a charger for charging a vehicle is installed; storing, in a database, information of a past event that has occurred in the charging station; and based on the information of the past event that has occurred in the charging station, and based on the information of the past event in the virtual space, implementing, in the virtual space, the past event that has occurred in the charging station and reproducing the implemented past event.

According to an embodiment, the past event information may include at least one of past charging history, charger failure history, customer accident history, and logistics history.

According to an embodiment, the reproducing may include a time-lapse function of performing, in the virtual space, at least one among a function of searching for data of the past charging history, a function of searching for the charger failure history, a function of searching for the customer accident history, and a function of searching for the logistics history.

According to an embodiment, the virtual space may be a digital twin in which the charging station is implemented as a three-dimensional space of the digital world, and the digital twin may store real-time information acquired from a charging station control system in a database, search for a past event that has occurred in the charging station based on a request by a user, reproduce a found past event in the virtual space by rendering the found past event in three dimensions, and reflect, in the virtual space, object information acquired in real time in the charging station.

According to an embodiment, the function of searching for data of the past charging history and the function of searching for the charger failure history may include providing the past charging history or the failure history by tagging a date, time, and vehicle information to daily charge data and failure data of each charger present in the charging station.

According to an embodiment, the reproducing may include, when information of the implemented past event is reproduced in the virtual space, reflecting a situation of the charging station at a past time point of the reproduced past event information identically in the virtual space.

According to an embodiment, the digital twin-based charging control method may further include transmitting control screen information based on a digital twin to a user device to be output to the user device.

According to an embodiment, the transmitting may include, based on information input through the user device, reflecting the input information in the digital twin.

According to an embodiment, the digital twin-based charging control method may further include linking and storing relevant tags according to each of particular events when the particular events occur, and when a user search is requested, searching for an event corresponding to the user search in a database by searching for a tag corresponding to a search term, and providing a found event.

According to an embodiment, the digital twin-based charging control method may further include, when an autonomous vehicle or a logistics robot approaches the charging station, identifying a position of the autonomous vehicle or the logistics robot in a charging station building using a digital twin in the corresponding charging station based on an inner three-dimensional shape of the charging station building, and guiding one path among an entry path, a charging path, and an exit path.

According to an embodiment, the guiding may include identifying position information of an object located in the charging station through a position sensor platform, and reflecting the identified position information in the digital twin in real time to perform digital twin-based path guidance.

According to an embodiment, the guiding may include generating a first moving path via which the autonomous vehicle moves to an empty charger when the autonomous vehicle enters the charging station and a second moving path via which the autonomous vehicle exits upon completion of charging of the autonomous vehicle, and transmitting the first and second moving path to the autonomous vehicle, by using the digital twin in the charging station.

A charging station control system according to an embodiment of the present invention may be configured to generate information of a virtual space based on infrastructure information about an infrastructure of a charging station which is real, collect and analyze sensing information from the infrastructure, recognize an object located in the charging station based on a plurality of pieces of the collected sensing information, reflect the recognized objects in the virtual space in which the plurality of pieces of collected sensing information are combined with each other in real time, and provide past history information and path information using the virtual space in which object information corresponding to the object is reflected.

A digital twin-based charging control server according to an embodiment of the present disclosure include a communication configured to receive information related to charging of a vehicle, the charging occurring in a charging station in which a charger for charging the vehicle is installed, from at least one of the charger and a sensor installed in the charging station, and a processor configured to generate a digital twin corresponding to the charging station and configured to reflect a real-time situation, and control at least one of a charger installed in the charging station and a vehicle that has entered the charging station through the digital twin.

According to an embodiment, the processor may reflect a situation that occurs in the charging station in the digital twin in real time, based on information obtained through sensing by the sensor installed in the charging station.

According to an embodiment, the sensor installed in the charging station may include at least one of a camera, a radar, and light detection and ranging (LiDAR), and the processor may render and reflect in real time, in the digital twin, a graphic object corresponding to an object of which movement is detected in the charging station, based on the information obtained through the sensing by the sensor.

According to an embodiment, when an object corresponding to a vehicle entering the charging station is selected through the digital twin, the processor may control the communication unit to communicate with the vehicle entering the charging station.

According to an embodiment, the processor may receive a vehicle control right from the vehicle entering the charging station and, on a basis that a preset condition is satisfied, remotely control the vehicle through the digital twin.

According to an embodiment, the preset condition may include at least one of a case when charging of the vehicle reaches a target charge and is complete, a case when a certain time has elapsed after charging is completed, a case when the vehicle in a standby state after charging is complete is present, and a condition set by a user.

According to an embodiment, when charging of the vehicle is performed at the charger, the processor may monitor the charging.

According to an embodiment, the processor may manage operations related to charging, the operations occurring in the charging station through the digital twin.

According to an embodiment, the processor may reproduce a past situation that occurred in the charging station through the digital twin.

According to an embodiment, when a graphic object corresponding to a vehicle is selected from the digital twin, the processor may provide a driving path of the vehicle to the vehicle.

According to an embodiment, the processor may reproduce, on the digital twin, a simulation of the vehicle driving along the driving path in the charging station.

According to an embodiment, even when the vehicle is located in a same position, the processor may set the driving path differently based on at least one of a position and a situation of a dynamic object located in the charging station.

According to an embodiment, the driving path may include a path via which the vehicle exits the charging station after completing the charging.

According to an embodiment, when a control right to control the vehicle is received from the vehicle and a driving request is received from the vehicle, the processor may remotely drive the vehicle along the driving path.

According to an embodiment, when a plurality of objects are selected on the digital twin and the plurality of objects are a same type of objects, the processor may perform batch control so that a same operation is performed on the plurality of selected objects.

A vehicle included in a digital twin-based charging station control system according to an embodiment of the present disclosure may include a communication unit communicably connected to a server included in the charging station based on entry of the vehicle into the charging station and configured to receive a digital twin corresponding to the charging station and configured to reflect a real-time situation; a display configured to display the digital twin and receive a user input applied to the digital twin; and a processor configured to control the display to output a first path to a charger capable of charging in the charging station and display, on the digital twin, a second path to an exit from the charging station when the charging is stopped.

According to an embodiment, when communicably connected to the server, the processor may transmit information related to a type of the charger capable of charging to the server, and receive the first path to the charger capable of charging from the server and output the first path onto the digital twin.

According to an embodiment, when a plurality of chargers are capable of charging, the processor may display the plurality of chargers capable of charging to be identifiable on the digital twin, and when one of the plurality of chargers is selected, a path to the selected charger may be output onto the digital twin.

According to an embodiment, when a request for controlling driving along the first path is received from the server, the processor may transmit a control right to control driving of the vehicle to the server.

According to an embodiment, the processor may perform autonomous driving along the first path under control by the server to which the control right is transmitted, and the driving along the first path may be reflected and output onto the digital twin.

According to an embodiment, when an object corresponding to a charger other than a charger corresponding to a destination of the first path is selected through the digital twin, the processor may transmit information about the selected other charger to the server, and receive a path to the selected other charger and output the path onto the digital twin, and perform autonomous driving along the path to the selected other charger under control by the server.

According to an embodiment, the processor may provide a simulation of driving to a position selected by a user through the digital twin.

According to an embodiment, the processor may provide additional information related to a location in a periphery of the charging station through the digital twin.

According to an embodiment, when charging of the vehicle is stopped, the processor may perform different controls depending on whether a user is present in the vehicle.

According to an embodiment, in such a case that a user is present in the vehicle when charging of the vehicle is stopped, the processor may output a second path to an exit from the charging station onto the digital twin, and transmit, to the server, a control right to control driving of the vehicle to perform autonomous driving to the second path according to a request by the user.

According to an embodiment, when the user is not present in the vehicle when charging of the vehicle is stopped, the processor may receive information about a standby location in the charging station and a driving path to the standby location from the server, and when a movement request to the vehicle is received from a pre-authenticated user terminal, the processor may transmit a control right to control the vehicle to the server, and the vehicle may be moved along the driving path to the standby location under control by the server.

According to an embodiment, the processor may receive charging information from the server and output information about a charging progress state onto the digital twin.

According to an embodiment, the processor may receive service information provided by the charging station from the server, output the service information through the digital twin, and perform payment for a service selected by the user.

Details of other embodiments are included in the detailed description and drawings.

### Advantageous Effects of Invention

According to an embodiment of the present disclosure, one or more of the following advantages may be provided.

First, according to the present disclosure, an effect of providing a new interface capable of performing intuitive and efficient control of a charging station through a digital twin may be obtained.

Second, according to the present disclosure, through the digital twin, vehicles being charged and chargers in a charging station may be managed, and charging-related services as well as charging-related controls may be easily provided.

Third, according to the present disclosure, a charging state, information about a periphery of a charging station, and an autonomous driving simulation in the charging station may be provided to a vehicle through the digital twin to thereby obtain an effect of providing an optimized user interface to the user present in the vehicle during charging.

The effects of the present disclosure are not limited to those effects mentioned above, and other effects not mentioned may be clearly understood by those skilled in the art from the description of the appended claims.

### Brief Description of Drawings

FIG. 1 is a view illustrating an appearance of a vehicle in accordance with an embodiment of the present disclosure.
FIG. 2 is a diagram illustrating an appearance of the vehicle in accordance with an embodiment of the present disclosure at various angles from outside.
FIGS. 3 and 4 are diagrams illustrating an inside of the vehicle in accordance with an embodiment of the present disclosure.
FIGS. 5 and 6 are diagrams illustrating objects in accordance with an embodiment of the present disclosure.
FIG. 7 is a block diagram illustrating a vehicle in accordance with an embodiment of the present disclosure.
FIG. 8 is a conceptual diagram for explaining a digital twin-based charging station control system in the present disclosure.
FIGS. 9, 10, and 11 are conceptual diagrams for explaining functions that may be provided by a charging station control system in the present disclosure.
FIG. 12 is a flowchart for explaining a method of controlling a system when a vehicle enters a charging station in accordance with an embodiment of the present disclosure.
FIG. 13 is a conceptual diagram for explaining a user interface output from the charging station control server through a digital twin in a case of a failure of a charger in accordance with an embodiment of the present disclosure.
FIG. 14 is a flowchart for explaining a method of controlling the system when a delivery vehicle enters the charging station in accordance with an embodiment of the present disclosure.
FIG. 15 is a flowchart for explaining a data flow between the charging station control server and a vehicle when the vehicle enters the charging station in accordance with an embodiment of the present disclosure.
FIGS. 16 and 17 are conceptual diagrams for explaining a control method performed by the system to autonomously drive a vehicle in the charging station upon completion of charging in accordance with an embodiment of the present disclosure.

### Mode for the Invention

Description will now be given in detail according to one or more embodiments disclosed herein, with reference to the accompanying drawings. For the sake of brief description with reference to the drawings, the same or equivalent components may be provided with the same or similar reference numbers, and description thereof will not be repeated. A suffix "module" or "unit" used for elements disclosed in the following description is merely intended for easy description of the specification, and the suffix itself is not intended to give any special meaning or function. In describing embodiments of the present disclosure, if a detailed explanation for a related known function or construction is considered to unnecessarily divert the gist of the present disclosure, such explanation has been omitted but would be understood by those skilled in the art. The accompanying drawings are used to help easily understand various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element can be connected with the another element or intervening elements may also be present. In contrast, when an element is referred to as being "directly connected with" another element, there are no intervening elements present.

A singular representation may include a plural representation unless it represents a definitely different meaning from the context.

Terms such as "include" or "has" are used herein and should be understood that they are intended to indicate an existence of several components, functions or steps, disclosed in the specification, and it is also understood that greater or fewer components, functions, or steps may likewise be utilized.

A vehicle described in this specification may be understood as a conception including automobiles, motorcycles, and the like. Hereinafter, the vehicle will be described based on a car.

The vehicle described herein may be a conception including all of an internal combustion engine car having an engine as a power source, a hybrid vehicle having an engine and an electric motor as power sources, an electric vehicle having an electric motor as a power source, and the like.

In the following description, a left side of a vehicle refers to a left side in a driving direction of the vehicle, and a right side of the vehicle refers to a right side in the driving direction.

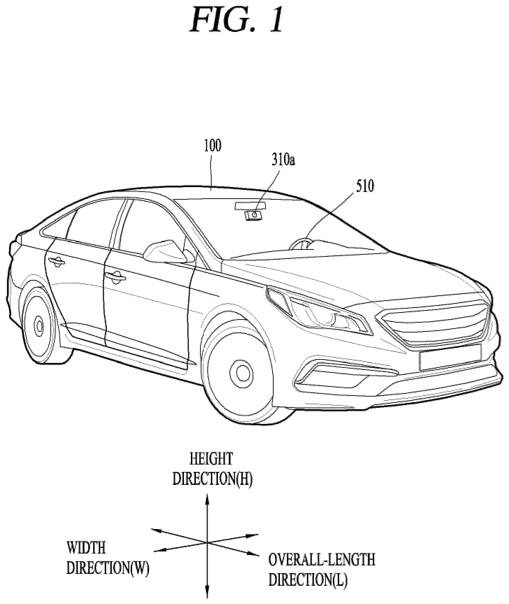

FIG. 1 is a view illustrating an appearance of a vehicle in accordance with an embodiment of the present disclosure.

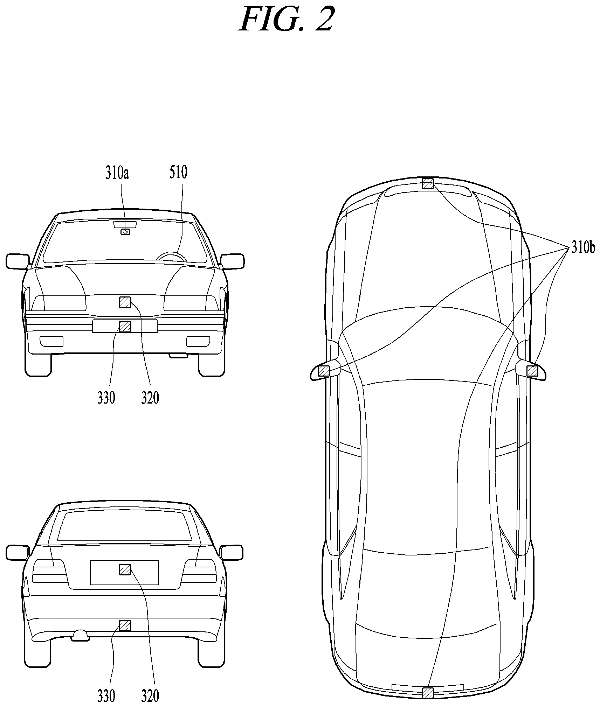

FIG. 2 is a diagram illustrating an appearance of the vehicle in accordance with an embodiment of the present disclosure at various angles from outside.

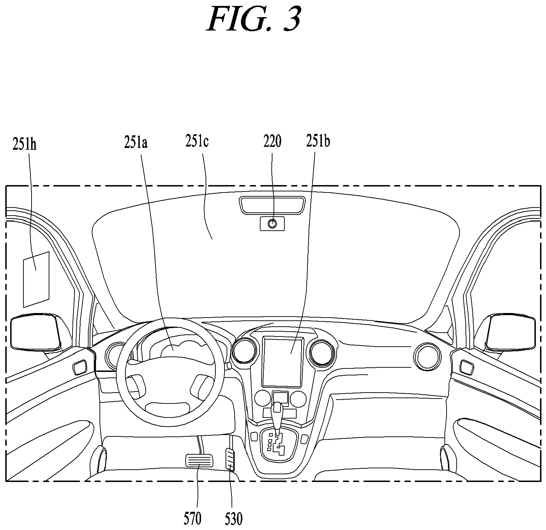

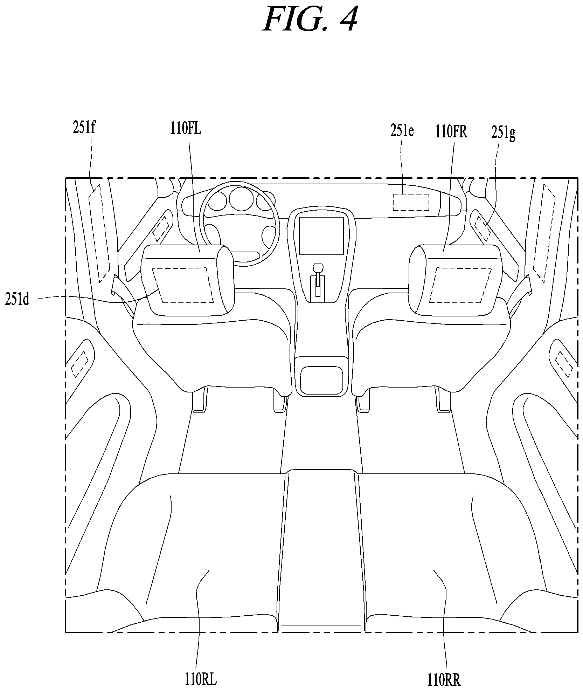

FIGS. 3 and 4 are diagrams illustrating an inside of the vehicle in accordance with an embodiment of the present disclosure.

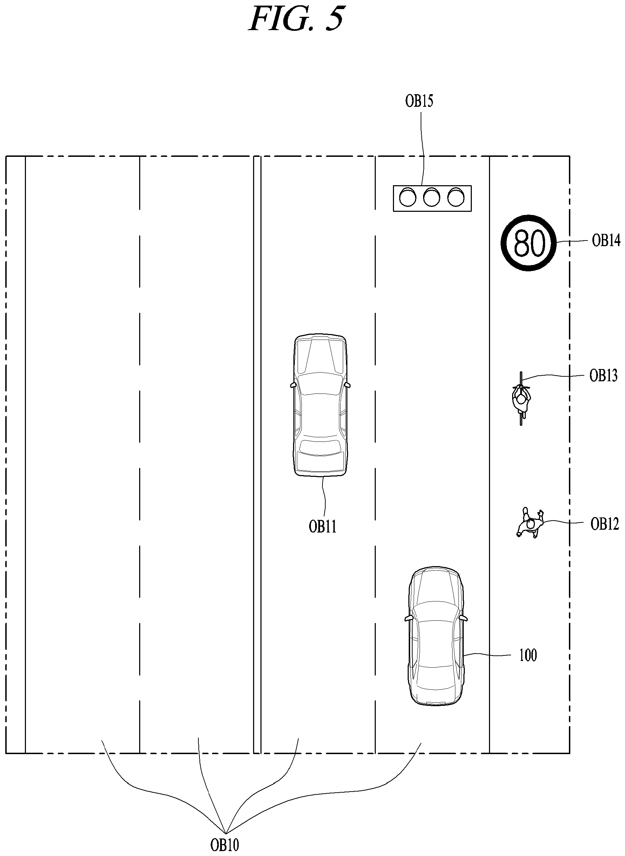

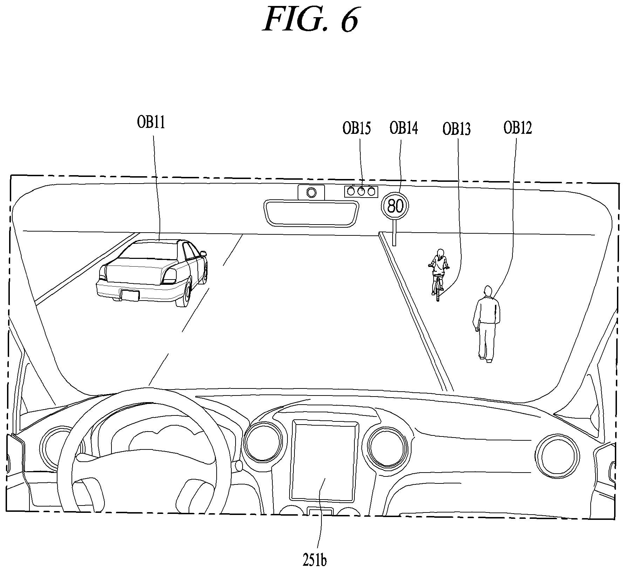

FIGS. 5 and 6 are diagrams illustrating objects in accordance with an embodiment of the present disclosure.

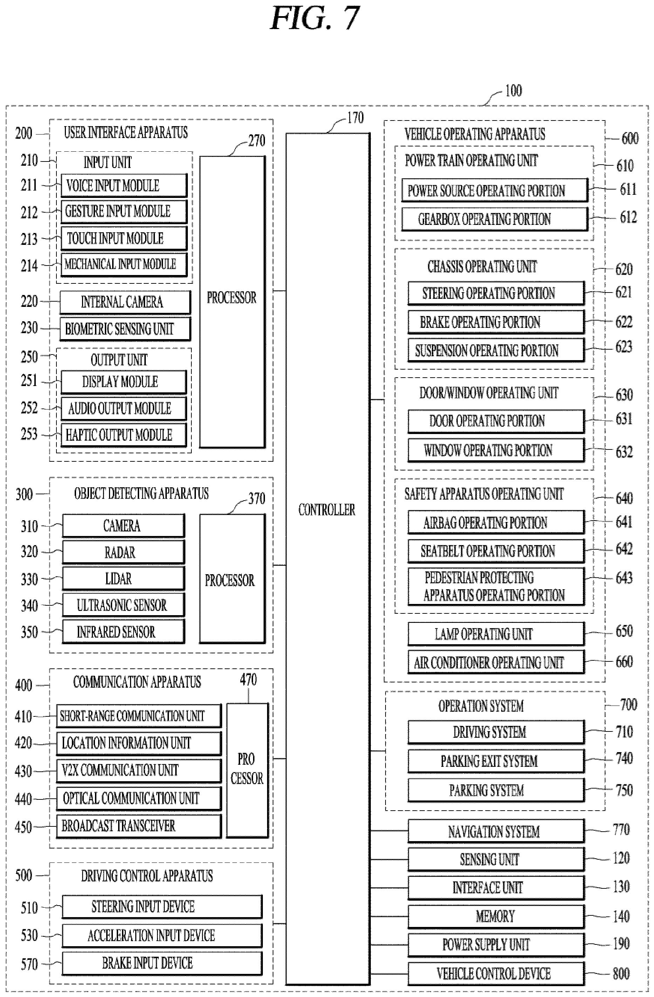

FIG. 7 is a block diagram illustrating a vehicle in accordance with an embodiment of the present disclosure.

Referring to FIGS. 1 through 7, a vehicle 100 may include wheels turning by a driving force, and a steering apparatus 510 for adjusting a driving (ongoing, moving) direction of the vehicle 100.

The vehicle 100 may be an autonomous vehicle.

The vehicle 100 may be switched into an autonomous mode or a manual mode based on a user input.

For example, the vehicle 100 may be converted from the manual mode into the autonomous mode or from the autonomous mode into the manual mode based on a user input received through a user interface apparatus 200.

The vehicle 100 may be switched into the autonomous mode or the manual mode based on driving environment information. The driving environment information may be generated based on object information provided from an object detection device 300.

For example, the vehicle 100 may be switched from the manual mode into the autonomous mode or from the autonomous mode into the manual mode based on driving environment information generated in the object detecting apparatus 300.

In an example, the vehicle 100 may be switched from the manual mode into the autonomous mode or from the autonomous mode into the manual mode based on driving environment information received through a communication apparatus 400.

The vehicle 100 may be switched from the manual mode into the autonomous mode or from the autonomous module into the manual mode based on information, data or signal provided from an external device.

When the vehicle 100 is driven in the autonomous mode, the vehicle 100 may be driven based on an operation system 700.

For example, the autonomous vehicle 100 may be driven based on information, data or signal generated in a driving system 710, a parking exit system 740 and a parking system 750.

When the vehicle 100 is driven in the manual mode, the autonomous vehicle 100 may receive a user input for driving through a driving control apparatus 500. The vehicle 100 may be driven based on the user input received through the driving control apparatus 500.

An overall length refers to a length from a front end to a rear end of the vehicle 100, a width refers to a width of the vehicle 100, and a height refers to a length from a bottom of a wheel to a roof. In the following description, an overall-length direction L may refer to a direction which is a criterion for measuring the overall length of the vehicle 100, a width direction W may refer to a direction that is a criterion for measuring a width of the vehicle 100, and a height direction H may refer to a direction that is a criterion for measuring a height of the vehicle 100.

As illustrated in FIG. 7, the vehicle 100 may include a user interface apparatus 200, an object detecting apparatus 300, a communication apparatus 400, a driving control apparatus 500, a vehicle operating apparatus 600, an operation system 700, a navigation system 770, a sensing unit 120, an interface unit 130, a memory 140, a controller 170 and a power supply unit 190.

According to embodiments, the vehicle 100 may include more components in addition to components to be explained in this specification or may not include some of those components to be explained in this specification.

The user interface apparatus 200 is an apparatus for communication between the vehicle 100 and a user. The user interface apparatus 200 may receive a user input and provide information generated in the vehicle 100 to the user. The vehicle 100 may implement user interfaces (Uls) or user experiences (UXs) through the user interface apparatus 200.

The user interface apparatus 200 may include an input unit 210, an internal camera 220, a biometric sensing unit 230, an output unit 250 and a processor 270.

According to embodiments, the user interface apparatus 200 may include more components in addition to components to be explained in this specification or may not include some of those components to be explained in this specification.

The input unit 200 may allow the user to input information. Data collected in the input unit 120 may be analyzed by the processor 270 and processed as a user's control command.

The input unit 200 may be disposed inside the vehicle. For example, the input unit 200 may be disposed on one area of a steering wheel, one area of an instrument panel, one area of a seat, one area of each pillar, one area of a door, one area of a center console, one area of a headlining, one area of a sun visor, one area of a wind shield, one area of a window, or the like.

The input unit 200 may include a voice input module 211, a gesture input module 212, a touch input module 213, and a mechanical input module 214.

The audio input module 211 may convert a user's voice input into an electric signal. The converted electric signal may be provided to the processor 270 or the controller 170.

The voice input module 211 may include at least one microphone.

The gesture input module 212 may convert a user's gesture input into an electric signal. The converted electric signal may be provided to the processor 270 or the controller 170.

The gesture input module 212 may include at least one of an infrared sensor and an image sensor for detecting the user's gesture input.

According to some embodiments, the gesture input module 212 may detect a user's three-dimensional (3D) gesture input. To this end, the gesture input module 212 may include a light emitting diode outputting a plurality of infrared rays or a plurality of image sensors.

The gesture input module 212 may detect the user's 3D gesture input by a time of flight (TOF) method, a structured light method or a disparity method.

The touch input module 213 may convert the user's touch input into an electric signal. The converted electric signal may be provided to the processor 270 or the controller 170.

The touch input module 213 may include a touch sensor for detecting the user's touch input.

According to an embodiment, the touch input module 213 may be integrated with the display module 251 so as to implement a touch screen. The touch screen may provide an input interface and an output interface between the vehicle 100 and the user.

The mechanical input module 214 may include at least one of a button, a dome switch, a jog wheel, and a jog switch. An electric signal generated by the mechanical input module 214 may be provided to the processor 270 or the controller 170.

The mechanical input module 214 may be arranged on a steering wheel, a center fascia, a center console, a cockpit module, a door and the like.

The internal camera 220 may acquire an internal image of the vehicle. The processor 270 may detect a user's state based on the internal image of the vehicle. The processor 270 may acquire information related to the user's gaze from the internal image of the vehicle. The processor 270 may detect a user gesture from the internal image of the vehicle.

The biometric sensing unit 230 may acquire the user's biometric information. The biometric sensing unit 230 may include a sensor for detecting the user's biometric information and acquire fingerprint information and heart rate information regarding the user using the sensor. The biometric information may be used for user authentication.

The output unit 250 may generate an output related to a visual, auditory or tactile signal.

The output unit 250 may include at least one of a display module 251, an audio output module 252 and a haptic output module 253.

The display module 251 may output graphic objects corresponding to various types of information.

The display module 251 may include at least one of a liquid crystal display (LCD), a thin film transistor-LCD (TFT LCD), an organic light-emitting diode (OLED), a flexible display, a three-dimensional (3D) display and an e-ink display.

The display module 251 may be inter-layered or integrated with a touch input module 213 to implement a touch screen.

The display module 251 may be implemented as a head up display (HUD). When the display module 251 is implemented as the HUD, the display module 251 may be provided with a projecting module so as to output information through an image which is projected on a windshield or a window.

The display module 251 may include a transparent display. The transparent display may be attached to the windshield or the window.

The transparent display may have a predetermined degree of transparency and output a predetermined screen thereon. The transparent display may include at least one of a thin film electroluminescent (TFEL), a transparent OLED, a transparent LCD, a transmissive transparent display and a transparent LED display. The transparent display may have adjustable transparency.

Meanwhile, the user interface apparatus 200 may include a plurality of display modules 251a to 251g.

The display module 251 may be disposed on one area of a steering wheel, one area 521a, 251b, 251e of an instrument panel, one area 251d of a seat, one area 251f of each pillar, one area 251g of a door, one area of a center console, one area of a headlining or one area of a sun visor, or implemented on one area 251c of a windshield or one area 251h of a window.

The audio output module 252 converts an electric signal provided from the processor 270 or the controller 170 into an audio signal for output. To this end, the audio output module 252 may include at least one speaker.

The haptic output module 253 generates a tactile output. For example, the haptic output module 253 may vibrate the steering wheel, a safety belt, a seat 110FL, 110FR, 110RL, or 110RR such that the user may recognize such output.

The processor 270 may control an overall operation of each unit of the user interface apparatus 200.

According to an embodiment, the user interface apparatus 200 may include a plurality of processors 270 or may not include any processor 270.

When the processor 270 is not included in the user interface apparatus 200, the user interface apparatus 200 may operate according to a control of a processor of another apparatus within the vehicle 100 or the controller 170.

Meanwhile, the user interface apparatus 200 may be called as a display apparatus for vehicle.

The user interface apparatus 200 may operate according to the control of the controller 170.

The object detecting apparatus 300 is an apparatus for detecting an object located at outside of the vehicle 100.

The object may be a variety of objects associated with driving (operation) of the vehicle 100.

Referring to FIGS. 5 and 6, an object O may include a traffic lane OB10, another vehicle OB11, a pedestrian OB12, a two-wheeled vehicle OB13, traffic signals OB14 and OB15, light, a road, a structure, a speed hump, a terrain, an animal and the like.

The lane OB10 may be a driving lane, a lane next to the driving lane or a lane on which another vehicle comes in an opposite direction to the vehicle 100. The lanes OB10 may be a concept including left and right lines forming a lane.

The another vehicle OB11 may be a vehicle which is moving around the vehicle 100. The another vehicle OB11 may be a vehicle located within a predetermined distance from the vehicle 100. For example, the another vehicle OB11 may be a vehicle which moves before or after the vehicle 100.

The pedestrian OB12 may be a person located near the vehicle 100. The pedestrian OB12 may be a person located within a predetermined distance from the vehicle 100. For example, the pedestrian OB12 may be a person located on a sidewalk or roadway.

The two-wheeled vehicle OB12 may refer to a vehicle (transportation facility) that is located near the vehicle 100 and moves using two wheels. The two-wheeled vehicle OB12 may be a vehicle that is located within a predetermined distance from the vehicle 100 and has two wheels. For example, the two-wheeled vehicle OB13 may be a motorcycle or a bicycle that is located on a sidewalk or roadway.

The traffic signals may include a traffic light OB15, a traffic sign OB14 and a pattern or text drawn on a road surface.

The light may be light emitted from a lamp provided on another vehicle. The light may be light generated from a streetlamp. The light may be solar light.

The road may include a road surface, a curve, an upward slope, a downward slope and the like.

The structure may be an object that is located near a road and fixed on the ground. For example, the structure may include a streetlamp, a roadside tree, a building, an electric pole, a traffic light, a bridge and the like.

The terrain may include a mountain, a hill, and the like.

Meanwhile, objects may be classified into a moving object and a fixed object. For example, the moving object may be a concept including another vehicle and a pedestrian. The fixed object may be, for example, a traffic signal, a road, or a structure.

The object detecting apparatus 300 may include a camera 310, a radar 320, a light detection and ranging (LiDAR) 330, an ultrasonic sensor 340, an infrared sensor 350, and a processor 370.

In some embodiments, the object detecting apparatus 300 may further include other components in addition to the components described, or may not include some of the components described.

The camera 310 may be located on an appropriate portion outside the vehicle to acquire an external image of the vehicle. The camera 310 may be a mono camera, a stereo camera 310a, an around view monitoring (AVM) camera 310b, or a 360-degree camera.

For example, the camera 310 may be disposed adjacent to a front windshield within the vehicle to acquire a front image of the vehicle. Alternatively, the camera 310 may be disposed adjacent to a front bumper or a radiator grill.

For example, the camera 310 may be disposed adjacent to a rear glass within the vehicle to acquire a rear image of the vehicle. Alternatively, the camera 310 may be disposed adjacent to a rear bumper, a trunk or a tail gate.

For example, the camera 310 may be disposed adjacent to at least one of side windows within the vehicle to acquire a side image of the vehicle. Alternatively, the camera 310 may be disposed adjacent to a side mirror, a fender or a door.

The camera 310 may provide an acquired image to the processor 370.

The radar 320 may include electric wave transmitting and receiving portions. The radar 320 may be implemented as a pulse radar or a continuous wave radar according to a principle of emitting electric waves. The radar 320 may be implemented by a frequency modulated continuous wave (FMCW) scheme or a frequency shift keying (FSK) scheme according to a signal waveform in a continuous wave radar scheme.

The radar 320 may detect an object in a time of flight (TOF) manner or a phase-shift manner through the medium of electromagnetic waves, and detect a location of the detected object, a distance from the detected object and a relative speed with the detected object.

The radar 320 may be disposed on an appropriate location outside the vehicle for detecting an object which is located at a front, rear or side of the vehicle.

The LiDAR 330 may include laser transmitting and receiving portions. The LiDAR 330 may be implemented in a time of flight (TOF) manner or a phase-shift manner.

The LiDAR 330 may be implemented as a drive type or a non-drive type.

For the drive type, the LiDAR 330 may be rotated by a motor and detect an object near the vehicle 100.

For the non-drive type, the LiDAR 330 may detect, through light steering, objects which are located within a predetermined range based on the vehicle 100. The vehicle 100 may include a plurality of non-drive type LiDARs 330.

The lidar 330 may detect an object in a time of flight (TOF) manner or a phase-shift manner through the medium of laser light, and detect a location of the detected object, a distance from the detected object and a relative speed with the detected object.

The radar 330 may be disposed on an appropriate position outside the vehicle for detecting an object which is located at a front, rear or side of the vehicle.

The ultrasonic sensor 340 may include ultrasonic wave transmitting and receiving portions. The ultrasonic sensor 340 may detect an object based on an ultrasonic wave, and detect a position of the detected object, a distance from the detected object and a relative speed with the detected object.

The ultrasonic sensor 340 may be disposed on an appropriate position outside the vehicle for detecting an object located at the front, rear or side of the vehicle.

The infrared sensor 350 may include infrared light transmitting and receiving portions. The infrared sensor 340 may detect an object based on infrared light, and detect a location of the detected object, a distance from the detected object and a relative speed with the detected object.

The infrared sensor 350 may be disposed on an appropriate location outside the vehicle for detecting an object located at the front, rear or side of the vehicle.

The processor 370 may control an overall operation of each unit of the object detecting apparatus 300.

The processor 370 may detect an object based on an acquired image, and track the object. The processor 370 may execute operations, such as a calculation of a distance from the object, a calculation of a relative speed with the object and the like, through an image processing algorithm.

The processor 370 may detect an object based on a reflected electromagnetic wave which an emitted electromagnetic wave is reflected from the object, and track the object. The processor 370 may execute operations, such as a calculation of a distance from the object, a calculation of a relative speed with the object and the like, based on the electromagnetic wave.

The processor 370 may detect an object based on a reflected laser beam which an emitted laser beam is reflected from the object, and track the object. The processor 370 may execute operations, such as a calculation of a distance from the object, a calculation of a relative speed with the object and the like, based on the laser beam.

The processor 370 may detect an object based on a reflected ultrasonic wave which an emitted ultrasonic wave is reflected from the object, and track the object. The processor 370 may execute operations, such as a calculation of a distance from the object, a calculation of a relative speed with the object and the like, based on the ultrasonic wave.

The processor 370 may detect an object based on reflected infrared light which emitted infrared light is reflected from the object, and track the object. The processor 370 may execute operations, such as a calculation of a distance from the object, a calculation of a relative speed with the object and the like, based on the infrared light.

In some embodiments, the object detecting apparatus 300 may include a plurality of processors 370 or may not include any processor 370. For example, each of the camera 310, the radar 320, the lidar 330, the ultrasonic sensor 340 and the infrared sensor 350 may include the processor in an individual manner.

When the processor 370 is not included in the object detection device 300, the object detection device 300 may operate according to the control of a processor of an apparatus within the vehicle 100 or the controller 170.

The object detecting apparatus 400 may operate according to the control of the controller 170.

The communication apparatus 400 is an apparatus for performing communication with an external device. Here, the external device may be another vehicle, a mobile terminal or a server.

The communication apparatus 400 may perform the communication by including at least one of a transmitting antenna, a receiving antenna, and radio frequency (RF) circuit and RF device for implementing various communication protocols.

The communication apparatus 400 may include a short-range communication unit 410, a location information unit 420, a V2X communication unit 430, an optical communication unit 440, a broadcast transceiver 450 and a processor 470.

According to an embodiment, the communication apparatus 400 may further include other components in addition to the components described, or may not include some of the components described.

The short-range communication unit 410 is a unit for facilitating short-range communications. The short-range communication unit 410 may support short-range communication using at least one of Bluetooth^{™}, radio frequency identification (RFID), infrared data association (IrDA), ultra wideband (UWB), ZigBee, near field communication (NFC), wireless-fidelity (Wi-Fi), Wi-Fi Direct, and wireless universal serial bus (USB).

The short-range communication unit 410 may construct short-range area networks to perform short-range communication between the vehicle 100 and at least one external device.

The location information unit 420 is a unit for acquiring position information of the vehicle 100. For example, the location information unit 420 may include a global positioning system (GPS) module or a differential global positioning system (DGPS) module.

The V2X communication unit 430 is a unit for performing wireless communications with a server (vehicle to infra; (V2I)), another vehicle (vehicle to vehicle (V2V)), or a pedestrian (vehicle to pedestrian (V2P)). The V2X communication unit 430 may include an RF circuit capable of implementing a communication protocol with an infrastructure (V2I), a communication protocol between vehicles (V2V) and a communication protocol with a pedestrian (V2P).

The optical communication unit 440 is a unit for performing communication with an external device through the medium of light. The optical communication unit 440 may include an optical transmission part for converting an electric signal into an optical signal and transmitting the optical signal to the outside, and an optical reception part for converting the received optical signal into the electric signal.

According to an embodiment, the optical transmission part may be formed integrally with lamps provided on the vehicle 100.

The broadcast transceiver 450 is a unit for receiving a broadcast signal from an external broadcast managing server or transmitting a broadcast signal to the broadcast managing entity via a broadcast channel. The broadcast channel may include a satellite channel, a terrestrial channel, or both. The broadcast signal may include a TV broadcast signal, a radio broadcast signal, and a data broadcast signal.

The processor 470 may control an overall operation of each unit of the communication apparatus 400.

According to an embodiment, the communication apparatus 400 may include a plurality of processors 470 or may not include any processor 470.

When the processor 470 is not included in the communication apparatus 400, the communication apparatus 400 may operate according to the control of a processor of another device within the vehicle 100 or the controller 170.

Meanwhile, the communication apparatus 400 may implement a display apparatus for a vehicle together with the user interface apparatus 200. In this instance, the display apparatus for the vehicle may be referred to as a telematics apparatus or an audio video navigation (AVN) apparatus.

The communication apparatus 400 may operate according to the control of the controller 170.

The driving control apparatus 500 is an apparatus for receiving a user input for driving.

In a manual mode, the vehicle 100 may be operated based on a signal provided by the driving control apparatus 500.

The driving control apparatus 500 may include a steering input device 510, an acceleration input device 530 and a brake input device 570.

The steering input apparatus 510 may receive an input regarding a driving (ongoing) direction of the vehicle 100 from the user. The steering input apparatus 510 is preferably configured in the form of a wheel allowing a steering input in a rotating manner. According to some embodiments, the steering input device may also be configured in a shape of a touch screen, a touch pad or a button.

The acceleration input apparatus 530 may receive an input for accelerating the vehicle 100 from the user. The brake input apparatus 570 may receive an input for braking the vehicle 100 from the user. Each of the acceleration input apparatus 530 and the brake input apparatus 570 is preferably configured in the form of a pedal. According to some embodiments, the acceleration input apparatus or the brake input apparatus may also be configured in the form of a touch screen, a touch pad or a button.

The driving control apparatus 500 may operate according to the control of the controller 170.

The vehicle operating apparatus 600 is an apparatus for electrically controlling operations of various devices within the vehicle 100.

The vehicle operating apparatus 600 may include a power train operating unit 610, a chassis operating unit 620, a door/window operating unit 630, a safety apparatus operating unit 640, a lamp operating unit 650, and an air-conditioner operating unit 660.

According to an embodiment, the vehicle operating apparatus 600 may further include other components in addition to the components described, or may not include some of the components described.

In some examples, the vehicle operating apparatus 600 may include a processor. Each unit of the vehicle operating apparatus 600 may individually include a processor.

The power train operating unit 610 may control an operation of a power train apparatus.

The power train operating unit 610 may include a power source operating portion 611 and a gearbox operating portion 612.

The power source operating portion 611 may perform a control for a power source of the vehicle 100.

For example, upon using a fossil fuel-based engine as the power source, the power source operating portion 611 may perform an electronic control for the engine. Accordingly, an output torque and the like of the engine can be controlled. The power source operating portion 611 may adjust the engine output torque according to the control of the controller 170.

For example, upon using an electric energy-based motor as the power source, the power source operating portion 611 may perform a control for the motor. The power source operating portion 611 may adjust a rotating speed, a torque and the like of the motor according to the control of the controller 170.

The gearbox operating portion 612 may perform a control for a gearbox.

The gearbox operating portion 612 may adjust a state of the gearbox. The gearbox operating portion 612 may change the state of the gearbox into drive (forward) (D), reverse (R), neutral (N) or parking (P).

In some examples, when an engine is the power source, the gearbox operating portion 612 may adjust a locked state of a gear in the drive (D) state.

The chassis operating unit 620 may control an operation of a chassis apparatus.

The chassis operating unit 620 may include a steering operating portion 621, a brake operating portion 622 and a suspension operating portion 623.

The steering operating portion 621 may perform an electronic control for a steering apparatus within the vehicle 100. The steering operating portion 621 may change a driving direction of the vehicle.

The brake operating portion 622 may perform an electronic control for a brake apparatus within the vehicle 100. For example, the brake operating portion 622 may control an operation of brakes provided at wheels to reduce speed of the vehicle 100.

Meanwhile, the brake operating portion 622 may individually control each of a plurality of brakes. The brake operating portion 622 may differently control braking force applied to each of a plurality of wheels.

The suspension operating portion 623 may perform an electronic control for a suspension apparatus within the vehicle 100. For example, the suspension operating portion 623 may control the suspension apparatus to reduce vibration of the vehicle 100 when a bump is present on a road.

Meanwhile, the suspension operating portion 623 may individually control each of a plurality of suspensions.

The door/window operating unit 630 may perform an electronic control for a door apparatus or a window apparatus within the vehicle 100.

The door/window operating unit 630 may include a door operating portion 631 and a window operating portion 632.

The door operating portion 631 may perform the control for the door apparatus. The door operating portion 631 may control opening or closing of a plurality of doors of the vehicle 100. The door operating portion 631 may control opening or closing of a trunk or a tail gate. The door operating portion 631 may control opening or closing of a sunroof.

The window operating portion 632 may perform the electronic control for the window apparatus. The window operating portion 632 may control opening or closing of a plurality of windows of the vehicle 100.

The safety apparatus operating unit 640 may perform an electronic control for various safety apparatuses within the vehicle 100.

The safety apparatus operating unit 640 may include an airbag operating portion 641, a seatbelt operating portion 642 and a pedestrian protecting apparatus operating portion 643.

The airbag operating portion 641 may perform an electronic control for an airbag apparatus within the vehicle 100. For example, the airbag operating portion 641 may control the airbag to be deployed upon a detection of a risk.

The seatbelt operating portion 642 may perform an electronic control for a seatbelt apparatus within the vehicle 100. For example, the seatbelt operating portion 642 may control passengers to be motionlessly seated in seats 110FL, 110FR, 110RL, 110RR using seatbelts upon a detection of a risk.

The pedestrian protection apparatus operating portion 643 may perform an electronic control for a hood lift and a pedestrian airbag. For example, the pedestrian protection apparatus operating portion 643 may control the hood lift and the pedestrian airbag to be open up upon detecting pedestrian collision.

The lamp operating portion 650 may perform an electronic control for various lamp apparatuses within the vehicle 100.

The air-conditioner operating unit 660 may perform an electronic control for an air conditioner within the vehicle 100. For example, the air-conditioner operating unit 660 may control the air conditioner to supply cold air into the vehicle when internal temperature of the vehicle is high.

The vehicle operating apparatus 600 may include a processor. Each unit of the vehicle operating apparatus 600 may individually include a processor.

The vehicle operation device 600 may operate according to the control of the controller 170.

The operation system 700 is a system that controls various driving modes of the vehicle 100. The operation system 700 may be operated in the autonomous driving mode.

The operation system 700 may include a driving system 710, a parking exit system 740 and a parking system 750.

According to embodiments, the operation system 700 may further include other components in addition to components to be described, or may not include some of the components to be described.

Meanwhile, the operation system 700 may include a processor. Each unit of the operation system 700 may individually include at least one processor.

According to embodiments, the operation system 700 may be a sub concept of the controller 170 when it is implemented in a software configuration.

Meanwhile, according to embodiment, the operation system 700 may be a concept including at least one of the user interface apparatus 200, the object detecting apparatus 300, the communication apparatus 400, the vehicle operating apparatus 600, and the controller 170.

The driving system 710 may perform driving of the vehicle 100.

The driving system 710 may receive navigation information from a navigation system 770, transmit a control signal to the vehicle operation device 600, and perform driving of the vehicle 100.

The driving system 710 may receive object information from the object detecting apparatus 300, transmit a control signal to the vehicle operating apparatus 600 and perform driving of the vehicle 100.

The driving system 710 may receive a signal from an external device through the communication apparatus 400, transmit a control signal to the vehicle operating apparatus 600, and perform driving of the vehicle 100.

The parking exit system 740 may perform an exit of the vehicle 100 from a parking lot.

The parking exit system 740 may receive navigation information from the navigation system 770, transmit a control signal to the vehicle operating apparatus 600, and perform the exit of the vehicle 100 from the parking lot.

The parking exit system 740 may receive object information from the object detecting apparatus 300, transmit a control signal to the vehicle operating apparatus 600 and perform the exit of the vehicle 100 from the parking lot.

The parking exit system 740 may receive a signal from an external device through the communication apparatus 400, transmit a control signal to the vehicle operating apparatus 600, and perform the exit of the vehicle 100 from the parking lot.

The parking system 750 may perform parking of the vehicle 100.

The parking system 750 may receive navigation information from the navigation system 770, transmit a control signal to the vehicle operating apparatus 600, and park the vehicle 100.

The parking system 750 may receive object information from the object detecting apparatus 300, transmit a control signal to the vehicle operating apparatus 600 and park the vehicle 100.

The parking system 750 may receive a signal from an external device through the communication apparatus 400, transmit a control signal to the vehicle operating apparatus 600, and park the vehicle 100.

The navigation system 770 may provide navigation information. The navigation information may include at least one of map information, information regarding a set destination, path information according to the set destination, information regarding various objects on a path, lane information and current location information of the vehicle.

The navigation system 770 may include a memory and a processor. The memory may store the navigation information. The processor may control an operation of the navigation system 770.

According to embodiments, the navigation system 770 may update prestored information by receiving information from an external device through the communication apparatus 400.

According to embodiments, the navigation system 770 may be classified as a sub component of the user interface apparatus 200.

The sensing unit 120 may sense a status of the vehicle. The sensing unit 120 may include a posture sensor (e.g., a yaw sensor, a roll sensor, a pitch sensor, etc.), a collision sensor, a wheel sensor, a speed sensor, a tilt sensor, a weight-detecting sensor, a heading sensor, a gyro sensor, a position module, a vehicle forward/backward movement sensor, a battery sensor, a fuel sensor, a tire sensor, a steering sensor by a turn of a handle, a vehicle internal temperature sensor, a vehicle internal humidity sensor, an ultrasonic sensor, an illumination sensor, an accelerator position sensor, a brake pedal position sensor, and the like.

The sensing unit 120 may acquire sensing signals with respect to vehicle-related information, such as a posture, a collision, an orientation, a location (GPS information), an angle, a speed, an acceleration, a tilt, a forward/backward movement, a battery, a fuel, tires, lamps, internal temperature, internal humidity, a rotated angle of a steering wheel, external illumination, pressure applied to an accelerator, pressure applied to a brake pedal and the like.

The sensing unit 120 may further include an accelerator sensor, a pressure sensor, an engine speed sensor, an air flow sensor (AFS), an air temperature sensor (ATS), a water temperature sensor (WTS), a throttle position sensor (TPS), a TDC sensor, a crank angle sensor (CAS), and the like.

The interface unit 130 may serve as a path allowing the vehicle 100 to interface with various types of external devices connected thereto. For example, the interface unit 130 may be provided with a port connectable with a mobile terminal, and connected to the mobile terminal through the port. In this instance, the interface unit 130 may exchange data with the mobile terminal.

Meanwhile, the interface unit 130 may serve as a path for supplying electric energy to the connected mobile terminal. When the mobile terminal is electrically connected to the interface unit 130, the interface unit 130 supplies electric energy supplied from a power supply unit 190 to the mobile terminal according to the control of the controller 170.

The memory 140 is electrically connected to the controller 170. The memory 140 may store basic data for units, control data for controlling operations of units and input/output data. The memory 140 may be various storage apparatuses such as a ROM, a RAM, an EPROM, a flash drive, a hard drive, and the like in terms of hardware. The memory 140 may store various data for overall operations of the vehicle 100, such as programs for processing or controlling the controller 170.

According to embodiments, the memory 140 may be integrated with the controller 170 or implemented as a sub component of the controller 170.

The controller 170 may control an overall operation of each unit of the vehicle 100. The controller 170 may be referred to as an Electronic Control Unit (ECU).

The power supply unit 190 may supply power required for an operation of each element according to the control of the controller 170. Specifically, the power supply unit 190 may receive power supplied from an internal battery of the vehicle, and the like.

At least one processor and the controller 170 included in the vehicle 100 may be implemented using at least one of application specific integrated circuits (ASICs), digital signal processors (DSPs), digital signal processing devices (DSPDs), programmable logic devices (PLDs), field programmable gate arrays (FPGAs), processors, controllers, micro controllers, microprocessors, and electric units performing other functions.

Meanwhile, the vehicle 100 related to the present disclosure may include a vehicle control device 800.

The vehicle control device 800 may control at least one of the elements described with reference to FIG. 7. From this point of view, the vehicle control device 800 may be the controller 170.

However, the present disclosure is not limited thereto, and the vehicle control device 800 may be a separate configuration independent of the controller 170. When the vehicle control device 800 is implemented as a component independent of the controller 170, the vehicle control device 800 may be provided on a part of the vehicle 100.

Meanwhile, the vehicle control device 800 described herein may include all kinds of devices capable of controlling the vehicle, and may be, for example, a mobile terminal. When the vehicle control device 800 is a mobile terminal, the mobile terminal and the vehicle 100 may be connected to each other to be communicable through wired/wireless communication. In addition, the mobile terminal may control the vehicle 100 in various ways in a communicatively connected state.

When the vehicle control device 800 is a mobile terminal, the processor 870 described herein may be a controller of the mobile terminal.

Hereinafter, description will be given of an example that the vehicle control device 800 is an element separate from the controller 170 for the sake of explanation. In this specification, functions (operations) and control methods described in relation to the vehicle control device 800 may be executed by the controller 170 of the vehicle. In other words, all descriptions in relation to the vehicle control device 800 may be applied to the controller 170 in the same/similar manner.

Furthermore, the vehicle control device 800 described herein may include some of the components illustrated in FIG. 7 and various components included in the vehicle. For convenience of description, the components illustrated in FIG. 7 and the various components included in the vehicle will be described with separate names and reference numbers.

Meanwhile, the present disclosure may provide a digital twin-based charging station control system capable of controlling and managing a charging station through a digital twin.

Hereinafter, with reference to the attached drawings, the digital twin-based charging station control system capable of controlling events (situations, operations, functions, etc.) that occur in a charging station using a digital twin is described.

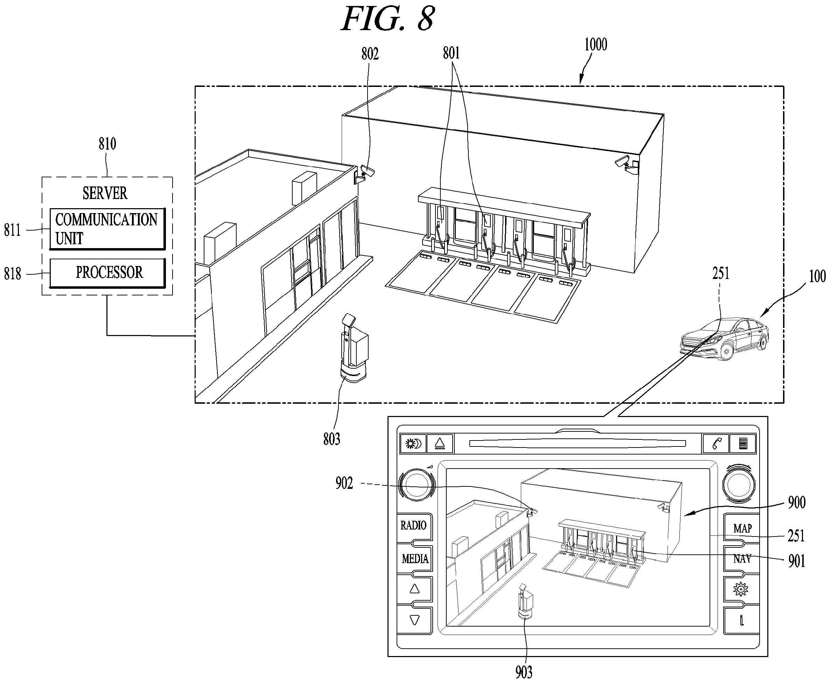

FIG. 8 is a conceptual diagram for explaining the digital twin-based charging station control system in the present disclosure.

In the present disclosure, a digital twin 900 configured to include at least one of a charger 801, a sensor 802, a robot 803, and the vehicle 100 each present in a charging station 1000 may be generated.

The digital twin 900 may be generated by a server 810 (or a charging control server) capable of controlling devices (a charger, a sensor, a robot, etc.) installed in the charging station 1000, or at an end of a cloud (not shown) capable of communicating with the server 810 and transmitted to the server 810.

The cloud refers to an external server configured to communicate with the server 810 installed in the charging station 1000. The cloud may manage servers 810 installed in a plurality of charging stations, and provide services, functions, charging-related information, data related thereto, which may be provided by the charging station through communication.

The server 810 refers to a charging control server included in the digital twin-based charging station control system in the present disclosure, and may communicate with all devices capable of performing communication, such as the charger 801, the sensor 802, the robot 803, the vehicle 100, etc. each installed in the charging station.

In detail, the server 810 for controlling charging based on a digital twin according to an embodiment of the present disclosure may include a communication unit 811 configured to receive information related to charging of the vehicle which occurs in the charging station 1000 in which the charger 801 for charging the vehicle 100 is installed, from at least one of the charger 801 and the sensor 802 installed in the charging station, and a processor 818 configured to generate the digital twin 900 corresponding to the charging station and configured to reflect a real-time situation, and control, through the digital twin, at least one of the charger 801 installed in the charging station and the vehicle 100 that has entered the charging station.

The server 810 may be connected wiredly/wirelessly to at least one of the charger 801, the sensor 802, and the robot 803 through the communication unit 811, and connected wiredly/wirelessly to the vehicle 100 entering the charging station 1000 to perform communication.

As an example, when the vehicle 100 is chargeably connected to the charger 801, the vehicle 100 may be wiredly connected to the server through the charger.

As described above, the vehicle 100 may include the vehicle control device 800 and may be communicatively connected to the server 810 through a communication unit (or the communication apparatus) 400 included in the vehicle.

The vehicle control device 800 may output the digital twin 900 of the charging station, the digital twin 900 being transmitted from the server 810 through the display module 251 included in the vehicle.

As an example, as the vehicle 100 enters the charging station 1000, when the vehicle 100 is communicably connected to the communication unit 811 of the server 810, the vehicle control device 800 may receive the digital twin 900 from the server 810, and output the received digital twin 900 to the display module 251 of the vehicle.

A digital twin refers to a representation of a machine or equipment, a thing, etc. in a real world into a virtual world inside a computer. Digital twin technology is used to identify and solve a problem that may occur, through mock tests before making a real product.

A digital twin refers to a copy of objects (things, spaces, environments, processes, procedures, etc.) present in a real world to be represented as a digital data model on a computer and interact with each other in real time.

A digital twin allows creation of a virtual model of an asset, such as a physical thing, a space, an environment, a person, a process, etc. using software to operate or simulate an action as if in a real world.

That is, a user may check information about real-world assets in a virtual world or accurately predict a future state of the assets through a mock test (simulation).

Unlike Metaverse which focuses on operation of an independent virtual world, the digital twin focuses on a combination of technologies such as the Internet of Things (IoT), sensors, and high-speed communication to reflect a state of reality in a virtual model in real time and operate the virtual model like twins.

In the present disclosure, the digital twin may be used to apply digital twin technology to an infrastructure of a city to produce precise road maps capable of helping autonomous driving and improve traffic efficiency.

In the present disclosure, the digital twin technology may be applied to a charging station to perform management (control) in the charging station on all events that occur in the charging station.

The server 810 included in a charging station control system in the present disclosure may generate the digital twin 900 configured to correspond to the charging station 800, and control the charger 801, the sensor 802, and robots 803 each present in the charging station as well as the vehicle 100 entering the charging station through the digital twin 900.

In addition, the server 810 may transmit the digital twin 900 configured to correspond to the charging station 800 to the vehicle 100 to be output to the display module 251 included in the vehicle.

The charging station control system in the present disclosure may be a digital twin platform based on a cloud.

The charging station control system may generate information of a virtual space (i.e. a digital twin) based on infrastructure information, which is an infrastructure of a real charging station, and collect and analyze a plurality of pieces of sensing information from the infrastructure (an infrastructure sensing data collection and analysis function).

Additionally, the charging station control system may recognize an object (a person, a vehicle, a robot, a facility, an obstacle, etc.) located in the charging station based on a plurality of pieces of the collected sensing information (a sensor fusion object recognition function).

In addition, the charging station control system may reflect the recognized object in the virtual space (the digital twin) in which the plurality of pieces of collected sensing information are combined with each other (or reflected) in real time, and provide past history information and path information using the virtual space in which object information corresponding to the object is reflected.

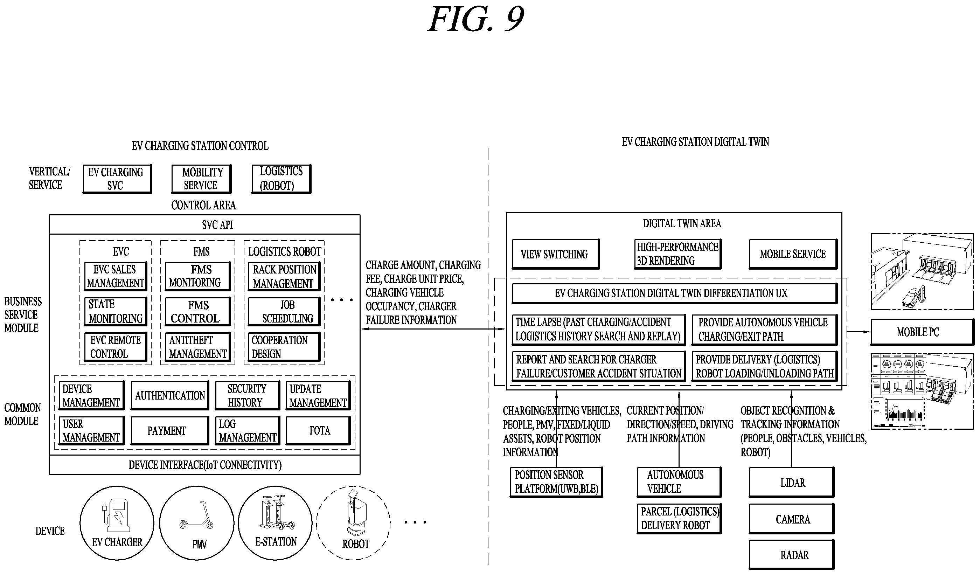

FIGS. 9, 10, and 11 are conceptual diagrams for explaining functions that may be provided by the charging station control system in the present disclosure.

Referring to FIG. 9, the charging station control system based on a digital twin in the present disclosure may provide a software solution (or software) for searching for past history data of moving objects such as vehicles being charged, users, robots, etc., facilities, logistics, obstacles, etc. and providing autonomous vehicle charging/exit paths in an electric vehicle (EV) charging station in a real world.

In detail, the present disclosure may interactively provide a time-lapse, a space for reproduction of past information, and autonomous vehicle charging/exit paths, report and search for charger failure/customer accident situations, and provide moving paths of parcel (logistics) delivery robots for loading/unloading in a virtual 3D space in which a digital world is combined with real world information through the digital twin.

The present disclosure may provide UXs that are intuitive and free from time and space constraints using this configuration, compared to a general control system.

Through the digital twin in the charging station, the present disclosure may reflect information about a real-world EV charging station (data of recognizing moving objects (vehicles, people, robots, etc.) and facilities in a periphery of the EV charging station, logistics, and obstacles) in the digital twin in real time, and provide a time lapse function including past charging/accident/logistics history search and replay functions.

In addition, the present disclosure may provide an interactive-type user interface (UX) including high-quality 3D image rendering and user interaction through the digital twin.

Referring to FIG. 9, the digital twin-based charging station control system in the present disclosure may provide an EV charging service (EV Charging SVC), a mobility service, and a logistics (robot) service under control by the server 810.

The server 810 may include a business service module capable of controlling electric vehicle charger (EVC) management, a vehicle control service (a fleet management system (FMS)), and a logistics robot 803. The business service module may be included in the processor 818 or may be an independent module.

Additionally, the server 810 may include a common module configured to perform device management, authentication, security history management, update management, user management, payment, log management, firmware over the air (FOTA) management, etc. The common module may be included in the processor 818 or may be an independent module.

In addition, the server 810 may control various devices present in the charging station, such as the charger 801 for an EV, a personal mobility vehicle (PMV), an e-station capable of charging and mounting the PMV, and the robot 803.

The processor 818 of the server 810 generate a digital twin and reflect real-time situations in the digital twin with reference to various information collected through the communication unit 811 (e.g., a charge amount, a charging fee, a charge unit price, charging vehicle occupancy, and charger failure information each received from the charger 801), charging/exiting vehicles, people, PMVs, fixed/liquid assets, and robot position information each received from a position sensor platform (ultra wide band (UWB)), Bluetooth low energy (BLE) (or sensors), current position/direction/speed information received from vehicles (autonomous vehicles) and the robot (803) for parcel (logistics) delivery, driving path information, and object (dynamic objects such as people, obstacles, vehicles, robots, etc.) recognition and tracking information received from a LiDAR, a camera, and a radar (or a sensor).

View transition, high-performance 3D rendering, mobile services, etc. may be provided through a digital twin (a digital twin area) generated by the server 810 and used for control at a side of the server 810, or provided to a vehicle.

In addition, through the digital twin, the present disclosure may provide a differentiated interface and a UX for EV charging stations, a time lapse function including a function of searching for past charging/accident logistics history and a function of replaying past situations, a function of providing a path for vehicle charging/exiting (autonomous vehicles), a function of reporting and searching for charger failures/customer accidents, and a function of providing loading/unloading paths to parcel (logistics) delivery robots.

The digital twin may be transmitted and output to a display included in a server, a terminal (a mobile terminal, a tablet PC, a PC, etc.) linked to the server, a mobile terminal, a vehicle, or the like. Control and management of a charging station through the digital twin may be performed through user authentication.

In the present disclosure, the digital twin may search for past data, replay a past situation that occurred in a charging station, and provide an optimal moving path to autonomous vehicles/robots in advance.

In the present disclosure, the digital twin may search for and replay past charging/accident/logistics history, provide autonomous vehicle charging/exit paths, report and search for charger failures/customer accident situations, and provide loading/unloading paths to parcel (logistics) delivery robots.

In the present disclosure, the digital twin may be used to integrate daily charge data (a charge amount, time, a price) and failure data of each charger under control of EV charging with date and time/vehicle information/tag information to be combined and provided as past charging/failure history information.

In addition, in the present disclosure, the time lapse function in the digital twin may be used to intuitively search for and replay (speed adjustable) past charging/failure history by date and time.

In addition, in the present disclosure, a designated event such as a particular vehicle or a failure type may be searched for based on information tagged by a normal/accident type deep learning algorithm through the digital twin.

In addition, the digital twin in the present disclosure includes an internal 3D shape of a charging station building, and may provide efficient charging/exiting and loading/unloading paths to autonomous vehicles and delivery (logistics) robots, based on position information of vehicles, people, PMVs, fixed/liquid assets, and delivery robots sensed through a position sensor platform using UWB/BLE, etc., current position/direction/speed information received from autonomous vehicles, and object recognition and tracking information regarding people, obstacles, vehicles robots, etc. which is sensed by LiDARs, cameras, or radars.

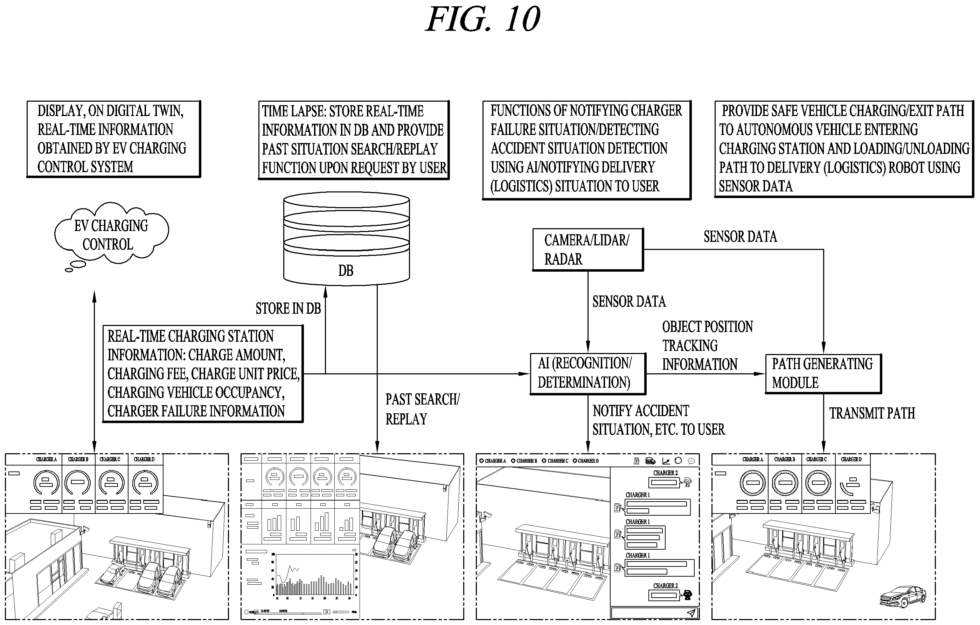

Referring to FIG. 10, the charging station control system in the present disclosure may display real-time information on a digital twin.

The server 810 may generate a virtual space (e.g., a digital twin), which is a virtual 3D space in which information transmitted from a real charging station is combined with a digital world based on information transmitted from the real charging station.

In addition, the charging station control system in the present disclosure may provide a time-lapse function of searching for past situations or providing a replay function according to a user request, by storing real-time information in a database DB included in the server.

In detail, the server 810 may store at least one of past charging history, charger failure details, customer accident situations, and logistics history, each having occurred in the charging station, in the database DB (or a memory (a storage space) of the server) in which data for generating a digital twin is stored.

That is, the server 810 may store, in the database, past event information (past charging history, failure details, customer accident situations, logistics history, etc.) which occurred in the charging station.

In addition, the charging station control system in the present disclosure use an artificial intelligence (AI) module (or a processor) included in the server to detect a faulty charger when a charger failure occurs, detect an accident situation that occurred in the charging station, or notify a parcel (logistics) delivery situation to a user terminal or a vehicle.

As an example, the server 810 may receive charging station information (e.g., a charging amount, a charge fee, a charge unit price, charging vehicle occupancy, charger failure information) transmitted from a charger, determine a faulty charger, an accident situation, and a logistics transport situation using sensor data obtained through sensing by a sensor (a camera, a LiDAR, a radar, a position sensor platform) installed in the charging station, and notify the faulty charger, the accident situation, and the logistics transport situation to a user.

To do so, the server 810 may provide one of a record of a search for past charging history data, a record of a search for a charger failure report, a record of report of a customer accident situation, and a record of a search for logistics history using the data stored in the database.

In other words, based on information of past events that occurred in the charging station and based on the past event information in the virtual space, the server 810 may implement and reproduce (replay), in the virtual space, a past event that occurred in the charging station.

Here, the past event information may include at least one of past charging history, charger failure history, customer accident history, and logistics history.

In addition, the server 810 may provide a function (hereinafter referred to as a time-lapse function) of replaying a found or requested situation (or reproducing a past situation) in the virtual space (the digital twin).

In other words, the server 810 may perform a time-lapse function of performing, in the virtual space, at least one of a function of searching for data of past charging history, a function of searching for charger failure report, a function of searching for customer accident history, and a function of searching for logistics history.

The virtual space may be a digital twin in which the charging station is implemented in a 3D space of a digital world.

Through the digital twin, the server 180 may store real-time information acquired from the charging station control system in the database, search for a past event that occurred in the charging station based on a user request, reproduce a found past event in the virtual space by rendering the found past event in three dimensions, and reflect object information, acquired in real time in the charging station, in the virtual space.

The server 810 may store real-time information acquired by the charging station control system in the database. In detail, the server 810 may receive sensor data obtained through sensing by a sensor installed in the charging station and charging-related data transmitted from the charger, and store the sensor data and the charging-related data in the database.

The server 810 may reflect the real-time information in the digital twin, i.e., the virtual space in real time.

In addition, based on a user request, the server 810 may intuitively search for past charging/failure history according to a date and time through the digital twin, i.e., the virtual space, or provide a function of monitoring a past charging or accident situation through a function of replaying (speed adjustable) an image of the past charging or accident situation, the image being rendered into a 3D image.

Additionally, based on a user request, the server 810 may display the object information in the virtual space together with status information of the object information, the object information being acquired in real time through the virtual space, i.e., the digital twin.

The server 810 may search for past charging history data in the virtual space through the time-lapse function and provide found past charging history data.

In this case, when providing the function of searching for past charging history data, the server 810 may combine daily charge data (a charge amount, time, a price) and failure data of each charger included in the charging station with date and time/vehicle information/tag information to be integrated into and provided as past charging/failure history information.

That is, the function of searching for past charging history data and the function of searching for charger failure report may be a function of providing past charging history or failure history by tagging a date, time, and vehicle information to the daily charge data and the failure data of each charger present in the charging station.

Meanwhile, when the server 810 reproduces past event information in the virtual space, a situation of the charging station at a time point of the reproduced past event information may be identically reflected in the virtual space.

In detail, when replaying past data in the virtual space (i.e., the digital twin), the server 810 may also reflect a situation in the charging station (e.g., presence of a vehicle in a charger (a charging slot) and a state of the charger (presence of a failure)) at a time point of occurrence of the replayed past data identically in the digital twin (identically to a past situation) and reproduce the past data. By doing so, the charging station control system in the present disclosure may provide a function of allowing a user to be capable of easily identifying a situation at the time of the occurrence (the past time) through the digital twin.

In addition, the server 810 may provide (transmit) control screen information based on the digital twin to a device of the user.

In detail, the server 180 may transmit the digital twin-based control screen information to the user device to be output to the user device.

The user may identify a situation in the charging station by receiving the control screen information through a display included in a personal mobile terminal or a vehicle.

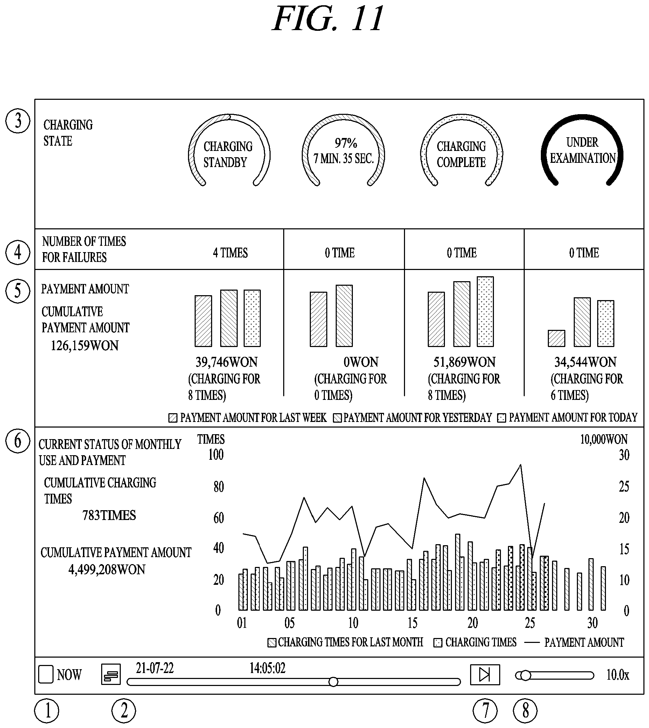

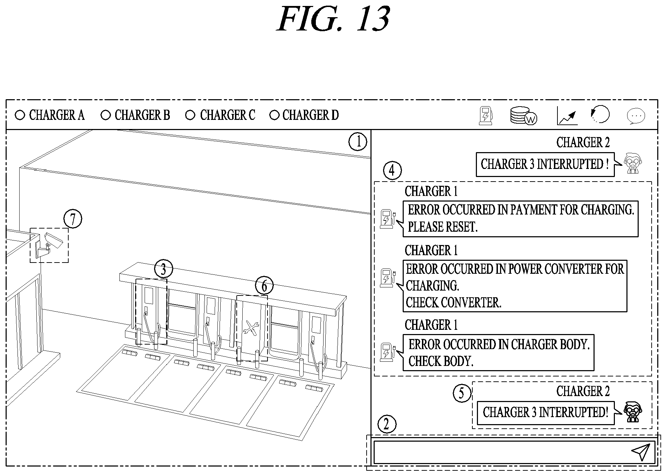

As an example, the digital twin-based control screen information may be as shown in FIG. 11 or 13.

In addition, based on information input through the user device, the server 810 may reflect the input information in the digital twin.

In detail, based on information input through the user device (a personal mobile terminal of the user or a display included in the vehicle), the server 810 may provide a digital twin-based control service of reflecting the input information in the digital twin, and providing the reflected input information to the user device through the digital twin.

When a report of a charger failure or a report of a customer accident situation is received through the user device, the server 810 may reflect real-world states of a charger and a customer in the digital twin based on the received report.

In addition, a digital twin-based charging control service provided by the charging station control system of the present disclosure may provide a function of searching for a particular vehicle or a designated event such as a failure type based on information tagged through the normal/accident type deep learning algorithm.

In detail, when particular events (e.g., charging completion, failure occurrence, logistics movement, etc.) are generated by the normal deep learning algorithm or the accident type deep learning algorithm, the server 810 may link and store relevant tags (charging information, failure information, a vehicle, time, a charging state in a charging station, etc.) according to each of the particular events.

When a user search is requested, the server 810 may search for an event corresponding to the user search in a database by searching for a tag corresponding to a search term, and provide the event.

In addition, the charging station control system in the present disclosure may use sensor data obtained through sensing by a sensor installed in the charging station to provide a safe entry/exit path to a vehicle entering the charging and provide a path (a loading/unloading path) for transporting a product to a delivery (logistics) robot.

Such paths may be generated by a path generating module (not shown) included in the server 810, or the processor 818. The server 810 may generate a path for a vehicle entering the charging station or a robot located in the charging station using the sensor data obtained through sensing by the sensor or object position tracking information in the charging station determined by an AI module (or a processor).

When an autonomous vehicle or a delivery (logistics) robot approaches a charging station (an EV charging station), the server 810 may further include a path guide module capable of identifying a position of the autonomous vehicle or the delivery robot in a charging station building using a digital twin in the corresponding charging station based on an inner 3D shape of the charging station building and guiding one of an entry path, a charging path, and an exit path.

For example, the server 810 may identify position information of an object (a vehicle, a person, a PMV, fixed/liquid assets, a delivery robot, etc.) in the charging station through a position sensor platform using UWB/BLE, etc. and reflect the position information in the digital twin in real time to perform digital twin-based path guidance.

The server 810 may use the digital twin in the charging station to generate a moving path via which an autonomous vehicle moves to an empty charging slot (a charger) when the autonomous vehicle enters the charging station, and generate a moving path via which the autonomous vehicle exits upon completion of charging, and transm its the generated moving paths to the autonomous vehicle.

By doing so, the charging station control system in the present disclosure may help movement of the autonomous vehicle that has entered the charging station using the digital twin in which a current situation is reflected in real time.

Referring to FIG. 11, the server 810 of the charging station control system in the present disclosure may provide a user interface related to charging.

A charging control interface provided by the server 810 may be output to overlap the digital twin.

For example, as illustrated in ① of FIG. 11, the server 810 may provide a function of switching between a real-time mode and a past data search mode through the charging control interface.

In addition, as illustrated in ② of FIG. 11, the server 810 may set a particular date and time in the past through the charging control interface.

In addition, as illustrated in ③ of FIG. 11, the server 810 may provide a charging state of each charger on a selected date and time through the charging control interface.

In addition, as illustrated in ④ of FIG. 11, the server 810 may provide a number of times of failures of each charger on the selected date and time through the charging control interface.

In addition, as illustrated in ⑤ of FIG. 11, the server 810 may provide a cumulative payment amount for each charger on a selected date and time and/or a cumulative payment amount/a number of charging times of a previous day through the charging control interface.

In addition, as illustrated in ⑥ of FIG. 11, the server 810 may provide a cumulative payment amount/a number of charging times of on a selected date and time in a corresponding month and a cumulative payment amount/a number of charging times until the same date of a previous month through the charging control interface.

In addition, as illustrated in ⑦ of FIG. 11, the server 810 may provide a function of performing replaying from the selected date and time through the charging control interface.

In addition, as illustrated in ⑧ of FIG. 11, the server 810 may provide a function of setting a playback speed during replaying through the charging control interface.

When past data is replayed, the server 7810 may also output the past data to the digital twin by identically reflecting, in the digital twin, presence of a vehicle in a charger and a situation of the charger (including presence of a failure) at time corresponding to the replayed past data. By doing so, a user may easily understand a situation at the time through the digital twin.

As described above, the server 810 for controlling charging based on a digital twin according to an embodiment of the present disclosure may include the communication unit 811 configured to receive information related to charging of a vehicle from at least one of a charger and a sensor installed in a charging station, the charging of the vehicle occurring in the charging station in which the charger for charging the vehicle is installed, and the processor 818 configured to generate a digital twin corresponding to the charging station and configured to reflect a real-time situation, and control at least one of the charger installed in the charging station and the vehicle that has entered the charging station through the digital twi n.

The processor 818 may reflect a situation that occurs in the charging station in the digital twin in real time, based on information obtained through sensing by the sensor 802 installed in the charging station.

The sensor 802 installed in the charging station may include at least one of a camera, a radar, and a LiDAR.

The processor 818 may render and reflect in real time, in the digital twin, a graphic object corresponding to an object of which movement is detected in the charging station based on the information obtained through sensing by the sensor.

In this case, the processor 818 may or may not reflect the sensor 802, installed in the charging station, in the digital twin. This may be determined according to a user setting.

When an object corresponding to a vehicle entering the charging station is selected through the digital twin, the processor 818 may control the communication unit 811 to communicate with the vehicle entering the charging station.

The processor 818 may receive a vehicle control right from the vehicle entering the charging station and perform remote control of the vehicle through the digital twin on a basis that a preset condition is satisfied.

For example, the processor 818 may receive a vehicle control right from the vehicle entering the charging station on a basis of communicable connection being performed with the vehicle, or receive a vehicle control right from the vehicle on a basis that an approval by a user of the vehicle is present.

As another example, in a case when the vehicle entering the charging station has a history of having transferred a vehicle control right to the server, on a basis that a communication connection is made to the vehicle, the processor 818 may receive a vehicle control right from the vehicle without having to separately obtaining an approval from the user of the vehicle.

The processor 818 may perform remote control of the vehicle through the digital twin on the basis that the preset condition is satisfied.

Here, the preset condition may include at least one of a case when charging of the vehicle reaches a target charge and is complete, a case when a certain time has elapsed after the charging is completed, a case when a vehicle in a standby state after the charging is complete is present, and a condition set by the user.

That is, when the preset condition is satisfied (including completion of the charging and interruption of the charging by the user), the processor 818 may perform remote control to move the vehicle to another position not to occupy the charger so that other vehicles may be charged.

When the charger charges the vehicle, the processor 818 may monitor the charging.

As an example, the monitoring of the charging may be performed through the charging control interface of FIG. 11.

The processor 818 may manage operations related to charging which occur in the charging station through the digital twin.

The management may be performed through the digital twin and various interfaces output to overlap the digital twin.

The processor 818 may reproduce a past situation that occurred in the charging station through the digital twin.

As described above, the processor 818 may reproduce a situation that has occurred in the charging station from a date and time desired by a user using the time-lapse function through the digital twin.

When a graphic object corresponding to a vehicle is selected from the digital twin, the processor 818 may provide a driving path of the vehicle to the vehicle.

The processor 818 may reproduce, on the digital twin, a simulation of the vehicle driving along the driving path in the charging station.

That is, when the driving path is provided to the vehicle, the processor 818 may simulate (reproduce) future driving of the vehicle through the digital twin in a state when the vehicle is not moving.

Even when the vehicle is located in a same position, the processor 818 may set the driving path differently based on at least one of a position and a situation of a dynamic object located in the charging station.

That is, the processor 818 may set the driving path differently depending on situations by using a sensor installed in the charging station to prevent a collision in consideration of a position of an object in the charging station, a charging state, presence of an obstacle, etc.

The driving path may include a path (an exit path) via which the vehicle exits the charging station after completing charging.

In addition, when a control right to control the vehicle and a driving request are received from the vehicle, the processor 818 may remotely drive the vehicle along the driving path.

When a plurality of objects are selected on the digital twin and the plurality of objects are a same type of objects, the processor 818 may perform batch control so that a same operation is performed on the plurality of selected objects.

For example, when a plurality of objects corresponding to a plurality of chargers are selected through the digital twin, since the plurality of selected objects are the same type (a charger), the processor 818 may control the plurality of objects together through one control input.

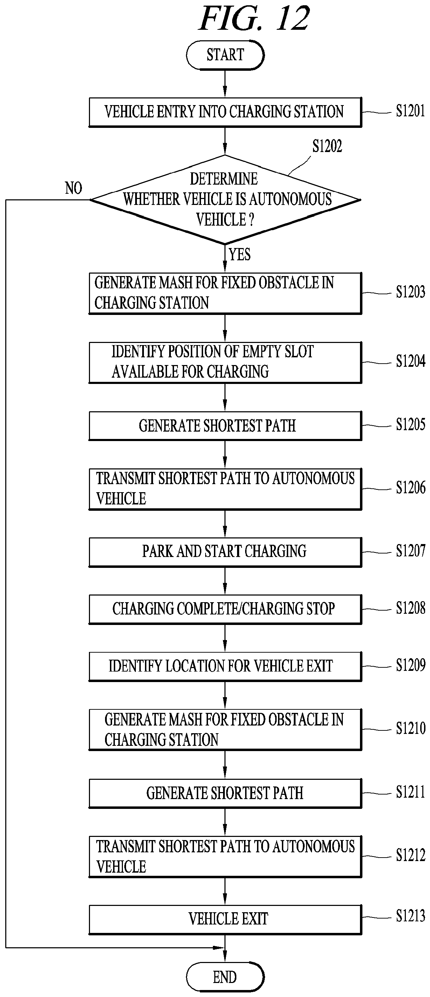

FIG. 12 is a flowchart for explaining a method of controlling a system when a vehicle enters a charging station in accordance with an embodiment of the present disclosure.

The processor 818 of a server may detect the vehicle entering the charging station through a sensor (S1201).

The processor 818 may determine whether the vehicle is capable of autonomous driving (S1202). For example, when the processor 818 is communicably connected to a vehicle that has entered the charging station, the processor 818 may determine whether the vehicle that has entered the charging station is an autonomous vehicle, on a basis that information related to the vehicle (information for identifying whether the vehicle is capable of autonomous driving) is received from the vehicle.

The processor 818 may generate a mash (or an area, a location) for a fixed obstacle in the charging station (S1203). Here, the fixed obstacle may include all types of obstacles that prevent the vehicle from driving, such as a chargers, a pillar, a sign, etc.

The processor 818 may identify a position of an empty slot (charger) available for charging (S1204). For example, the processor 818 may determine that a charger that does not transmit charging-related information is an empty slot, or identify an empty slot available for charging through a sensor (e.g., a camera).

Then, the processor 818 may generate a shortest path from a position of the vehicle to the empty slot available for charging (S1205) and transmit the generated shortest path to the vehicle (S1206).

In this case, when a vehicle control right is received from the vehicle, the processor 818 may remotely control the vehicle so that the vehicle moves along the shortest path.

When the vehicle is moved to the empty slot available for charging, the vehicle may park and start charging (S1207). When the charging reaches a target charge and is completed or the charging is stopped by the user (S1208), the processor 818 may check a position to which the vehicle exits (S1209).

In this case, the processor 818 may generate a mash (or a region, or an area) for the fixed obstacle in the charging station (S1210) and generate a shortest path for avoiding the fixed obstacle so that the vehicle may exit (S1211).

The processor 818 may deliver (transmit) the shortest path to the vehicle through the communication unit (S1212), and the vehicle may exit along the shortest path (S1213).

Likewise, when the vehicle control right is received from the vehicle, the processor 818 may remotely drive the vehicle to move to an exit along the shortest path.

FIG. 13 is a conceptual diagram for explaining a user interface output from a charging station control server through a digital twin in a case of a failure of a charger in accordance with an embodiment of the present disclosure.

When a charger failure occurs, the processor 818 may notify failure details to a manager of a charging station at the charging station control server or a user of a vehicle through a failure notification interface configured to notify the charger failure.

For example, as illustrated in ① of FIG. 13, the processor 818 may notify the user of a current state of a charger/customer and a state of a corresponding action via a chat window through the failure notification interface.

As illustrated in ② of FIG. 13, through the failure notification interface, the processor 818 may search for a text record displayed in the chat window via a command window or input a command corresponding to the current state of the charger/customer.

As illustrated in ③ of FIG. 13, the processor 818 may reflect the current state of the charger and the customer in the digital twin via the failure notification interface.

As illustrated in ④ of FIG. 13, the processor 818 may indicate the current state of the charger/customer via the chat window through the failure notification interface.

As illustrated in ⑤ of FIG. 13, the processor 818 may display a result of reflecting the command input to the command window in a real world and the digital twin, in a text form through the failure notification interface.

As illustrated in ⑥ of FIG. 13, the processor 818 may reflect a state in which the command is reflected in the digital twin through the failure notification interface.

As illustrated in ⑦ of FIG. 13, the processor 818 may determine an accident situation by recognizing an appearance of the customer using a camera (a closed-circuit television (CCTV)) and enable the accident situation to be reflected in the digital twin through the failure notification.

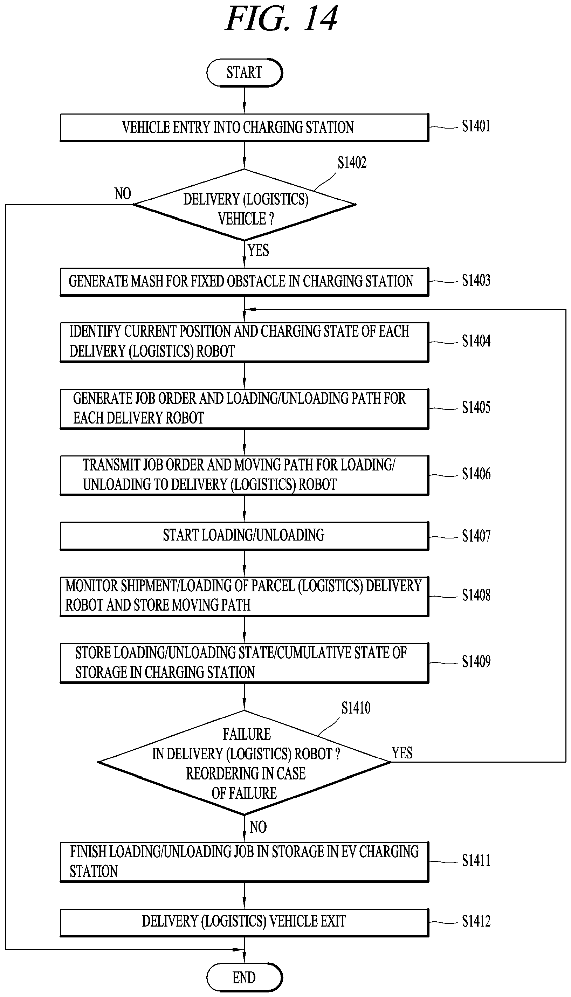

FIG. 14 is a flowchart for explaining a method of controlling the system when a delivery vehicle enters a charging station in accordance with an embodiment of the present disclosure.

Meanwhile, in the present disclosure, logistics transportation may be performed using the robot 803 in the charging station.

When the vehicle enters the charging station (S1401), the processor 818 of a server may determine whether a vehicle entering the charging station is a delivery vehicle or a logistics transport vehicle (such as a truck, etc.) (S1402).

For example, when the processor 818 receives information indicating a delivery vehicle from the vehicle after being connected to the vehicle through the communication unit, the processor 818 may determine that the vehicle entering the charging station is a delivery vehicle.

The processor 818 may generate a mash for a fixed obstacle in the charging station (S1403).

The processor 818 may check a current location of each robot 803 for parcel delivery through a sensor (e.g., a position sensor platform (UWB)) and receive and check a charging state from the robot 803 through the communication unit 811 (S1404).

The processor 818 may generate a work order and a loading/unloading moving path for each robot (S1405).

The loading/unloading moving path may be determined based on a location of the vehicle, a destination for transporting goods, map information of inside of the charging station, and a mash for fixed obstacles in the charging station.

The processor 818 may transmit a work order (job order) and the loading/unloading moving path to the robot 803 for parcel delivery (S1406).

The robot 803 may start loading/unloading according to the received work order and the received loading/unloading moving path (S1407).

The processor 818 may monitor shipment/loading by the robot 803 for delivery (logistics) and store a moving path (S1408).

The processor 818 may store a loading/unloading state and a cumulative state of a storage in the charging station (S1409).

The processor 818 may determine whether a failure has occurred in the robot 803. When a failure has occurred, the processor 818 may return to operation S1404. When a failure has not occurred, work of loading/unloading the goods to the storage in the charging station may be completed (S141 1).

Then, the processor 818 may control the vehicle to exit (S1412).

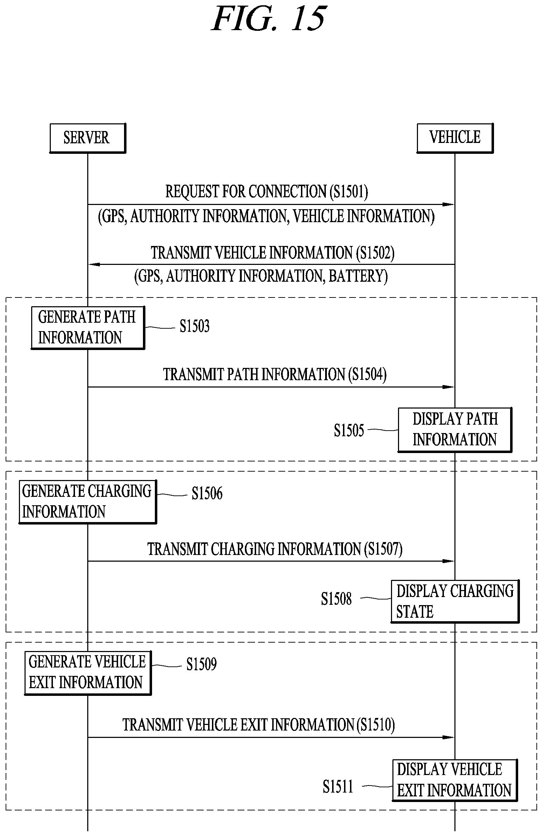

FIG. 15 is a flowchart for explaining a data flow between a charging station control server and a vehicle when the vehicle enters the charging station in accordance with an embodiment of the present disclosure.

When the vehicle enters the charging station, a charging station control system in the present disclosure may connect the vehicle to a server to enable communication, and generate a path for the vehicle (an incoming vehicle) entering the charging station.

For example, the charging station control system may establish a communication connection to exchange information between the incoming vehicle and a digital twin, and select a charger capable of charging (fast or slow) based on information about the incoming vehicle.

In addition, the charging station control system of the present disclosure may generate information of guidance between the vehicle and the charging station and transmit the information to the server. Then, in a case of a non-autonomous vehicle, the charging station control system may guide a path based on the transmitted information. In a case of an autonomous vehicles, the charging station control system may remotely control the vehicle based on the transmitted information.

To do so, referring to FIG. 15, when entry of the vehicle into the charging station is sensed by a sensor, the server 810 may request a communication connection to the vehicle 100 through the communication unit (S1501).

Then, when the communication connection is completed, the vehicle may transmit, to the server, vehicle information including at least one of GPS information, authority information (a vehicle control right), and battery information (S1502).

The server 810 may generate path information set such that the vehicle moves to a charger capable of charging, based on the received vehicle information and a type of chargers in the charging station and the charger capable of charging (S1503), and transmit the generated path information to the vehicle. (S1504).

Additionally, the server may transmit the digital twin to the vehicle, and information updated in real time may be reflected in the digital twin.

The vehicle 100 may display the received path information on the digital twin received from the server (S1505).

Additionally, the charging station control system in the present disclosure may monitor a charging state and request for an emergency situation.

In detail, the server 810 may monitor the charging state of the vehicle through the digital twin and, when the emergency situation occurs, notify the occurrence.

In addition, the server 810 may check and respond to a user request by chatting through the digital twin.

In addition, the server 810 may control information according to the user request to be reflected in the digital twin and displayed on the digital twin transmitted to the vehicle.

In addition, the server 810 may transmit and display the reflected information onto a user device (the vehicle or a user terminal).

Referring to FIG. 15, the server 810 may generate charging information about charging of the charger (S1506) and transmit the charging information to the vehicle (S1507).

The vehicle 100 may output the charging state by overlapping the digital twin through the charging control interface (see FIG. 11).

Then, when the charging is complete, the server 810 may generate vehicle exit information (S1509) and transmit the vehicle exit information to the vehicle (S1510).

The vehicle 100 may output the vehicle exit information (e.g., a driving path from a charging location to an exit from the charging station) onto the digital twin (S1511).

The server 810 may perform automatic vehicle exit or monitor the vehicle exit information.

For example, the server 810 may determine whether the vehicle may exit based on determination of a charging complete state. The determination of the charging complete state may be performed according to whether the preset condition described above is satisfied.

When a control right (authority) to take a vehicle out is received from the vehicle, the server 810 may automatically take out the vehicle or transmit information suggesting that the vehicle be taken out manually.

The server 810 may request to manual take-out of the vehicle after remotely starting the vehicle for vehicle exit.

The server 810 may reflect and output a location and a state of the taken out vehicle onto the digital twin. Then, the digital twin may be output to the vehicle or a terminal of a user.

The control of the vehicle described above may be performed by the vehicle control device 800 included in the vehicle.

The vehicle control device 800 may include a communication unit (the communication apparatus 400 of FIG. 7) communicably connected to a server included in the charging station based on entry into the charging station, and configured to receive a digital twin corresponding to the charging station and configured to reflect a real-time situation, the display module (or a touchscreen) 251 configured to display the digital twin and receive a user input applied to the digital twin, and a processor configured to control the display module to output a first path to a charger capable of charging in the charging station and display, on the digital twin, a second path to an exit from the charging station when the charging is stopped.

When communicably connected to the server, the processor of the vehicle control device may transmit information related to a type of the charger capable of charging to the server, and receive the first path to the charger capable of charging from the server to output the first path onto the digital twin.

When a plurality of chargers capable of charging are present, the processor of the vehicle control device may display the plurality of chargers capable of charging to be identifiable on the digital twin, and when one of the plurality of chargers is selected, a path to the selected charger may be output onto the digital twin.

When a request for controlling driving along the first path is received from the server, the processor of the vehicle control device may transmit a control right to control driving of the vehicle to the server.

The processor of the vehicle control device may perform autonomous driving along the first path under control by the server to which the control right is transmitted, and the driving along the first path may be reflected and output onto the digital twin.

When an object corresponding to a charger other than a charger corresponding to a destination of the first path is selected through the digital twin, the processor of the vehicle control device may transmit information about the selected other charger to the server, and receive a path to the selected other charger to be output onto the digital twin, and perform autonomous driving along the path to the selected other charger under control by the server.

The processor of the vehicle control device may provide a simulation of driving to a position selected by a user through the digital twin.

The processor of the vehicle control device may provide additional information related to a position located in a periphery of the charging station through the digital twin.

Here, the additional information may refer to information about a point of interest (POI) in a periphery of the charging station, and may refer to information about the corresponding position such as position information of the corresponding POI, services provided, and payment for the services.

When charging of the vehicle is stopped, the processor of the vehicle control device may perform different controls depending on whether a user is present in the vehicle.

For example, in such a case that a user is present in the vehicle when charging of the vehicle is stopped, the processor of the vehicle control device may output a second path to an exit from the charging station onto the digital twin, and transmit, to the server, a control right to control driving of the vehicle to perform autonomous driving to the second path according to a request by the user.

The processor of the vehicle control device may perform payment for a service selected by the user. The payment may be performed on the digital twin.

The server may generate an interface that allows payment on the digital twin and transmit the interface to the vehicle control device.

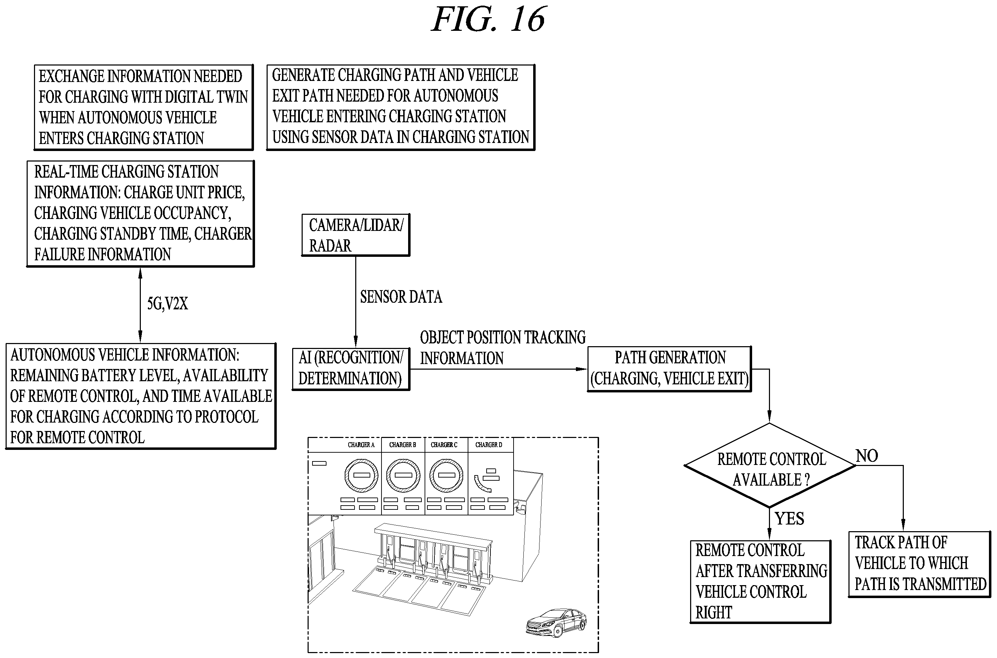

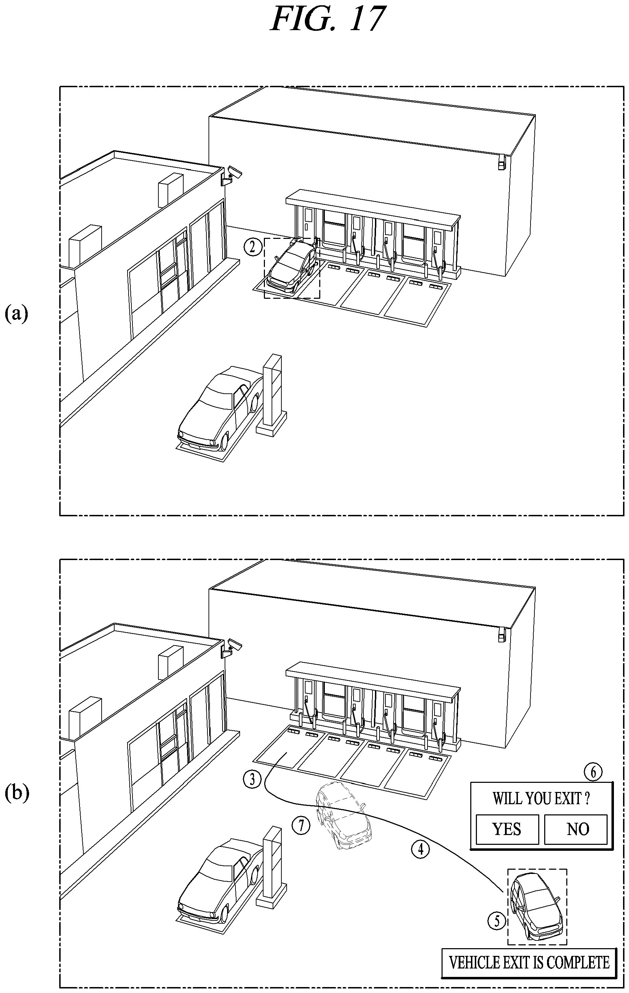

FIGS. 16 and 17 are conceptual diagrams for explaining a control method performed by the system to autonomously drive a vehicle in a charging station upon completion of charging in accordance with an embodiment of the present disclosure.

Referring to FIG. 16, when an autonomous vehicle enters the charging station, a charging station control system may exchange information needed for charging with a digital twin (in detail, the server).

The information needed for charging may include real-time charging station information (a charging unit price, charging vehicle occupancy, charging standby time, charger failure information, etc.) and vehicle information (a remaining battery level, availability of remote control, and time available for charging according to a protocol for remote control, etc.), and may be exchanged between the server and the vehicle through a communication unit.

The server 810 (or the AI module (or a processor) included in the server) may generate position estimation information of an object based on sensor data obtained through sensing by a sensor (a camera, a LiDAR, a radar), and generate paths of the vehicle (first and second paths) based on the position estimation information.

In addition, when remote control of the vehicle may be performed, the server 810 may receive a control right to perform driving from the vehicle and remotely control the vehicle to drive.

When the remote control of the vehicle may not be performed, the server may transmit the generated paths to the vehicle and track driving of the vehicle.

Referring to FIG. 17, as illustrated in (a) of FIG. 17, the server 810 may provide a digital twin screen via which a state inside the charging station and a vehicle exit situation may be monitored to a display in the vehicle or a terminal of a user of the vehicle (a mobile terminal, a tablet PC, etc.).

When the user selects the vehicle as illustrated in ② in (a) of FIG. 17, the server 810 may display a vehicle exit path on the digital twin in consideration of surrounding conditions (vehicles, people, obstacles etc.) for vehicle exit, a location of an exit, and a location of the vehicle as illustrated in ③ in (b) of FIG. 17.

As illustrated in ④ in (b) of FIG. 17, the vehicle control device 800 may reproduce a process of simulating the vehicle which is to drive to a destination for exit (e.g., an exit from the charging station) on the digital twin.

As illustrated in ⑤ in (b) of FIG. 17, the vehicle control device 800 may show arrival of the vehicle at the destination for exit and a selection area in advance.

As illustrated in ⑥ in (b) of FIG. 17, when the selection area is selected, the vehicle control device 800 may output a pop-up message asking whether to take out the vehicle onto the digital twin.

Then, as illustrated in ⑦ in (b) of FIG. 17, when a request to take out the vehicle is accepted in the pop-up message (when Yes is selected), the vehicle control device 800 may receive a control right from the vehicle to remotely control the vehicle to drive along the exit path, and reflect and output a current location of the vehicle into the digital twin in real time.

As illustrated in ⑧ in (b) of FIG. 17, when the vehicle arrives at the destination for exit, the vehicle control device 800 may output a vehicle exit complete message to the digital twin.

The destination for exit may include an exit from the charging station as well as a vehicle standby location.

According to an embodiment of the present disclosure, one or more of the following advantages may be provided.

First, according to the present disclosure, an effect of providing a new interface capable of performing intuitive and efficient control of a charging station through a digital twin may be obtained.

Second, according to the present disclosure, through the digital twin, vehicles being charged and chargers in a charging station may be managed, and charging-related services as well as charging-related controls may be easily provided.

Third, according to the present disclosure, a charging state, information about a periphery of a charging station, and an autonomous driving simulation in the charging station may be provided to a vehicle through the digital twin to thereby obtain an effect of providing an optimized user interface to the user present in the vehicle during charging.

The effects of the present disclosure are not limited to those effects mentioned above, and other effects not mentioned may be clearly understood by those skilled in the art from the description of the appended claims.

It is understood that a function/operation/control method performed by the server described above may be performed by the processor 818 of the server.

The vehicle control device 800 described above may be included in the vehicle 100.

In addition, the operation or control method of the vehicle control device 800 described above may be identically/similarly applied to an operation or control method of the vehicle 100 (or the controller 170).

For example, a description of detailed embodiments of the control method of the vehicle 100 (or the control method of the vehicle control device 800)

may be replaced by or derived from the description provided above to be applied an identical/similar manner.

Each of the operations may be performed not only by the vehicle control device 800 but also by the controller 170 included in the vehicle 100.

Further, all functions, configurations, or control methods performed by the vehicle control device 800 described above may be performed by the controller 170 provided in the vehicle 100. That is, all the control methods described in this specification may be applied to a control method of a vehicle or a control method of a control device.

Further, the vehicle control device 800 described above may be a mobile terminal. In this case, all functions, configurations, or control methods performed by the vehicle control device 800 described above may be performed by a controller provided in the mobile terminal. In addition, all the control methods described in this specification may be similarly applied to the method of controlling a mobile terminal in the same/similar way.

The present disclosure can be implemented as computer-readable codes in a program-recorded medium. The computer readable medium includes all kinds of recording devices in which data readable by a computer system is stored. Examples of the computer-readable medium include a hard disk drive (HDD), a solid state disk (SSD), a silicon disk drive (SDD), a ROM, a RAM, a CD-ROM, a magnetic tape, a floppy disk, an optical data storage device and the like. Also, the computer may include a processor or a controller. Therefore, the detailed description should not be limitedly construed in all of the aspects, and should be understood to be illustrative. The scope of the present disclosure should be determined by reasonable interpretation of the appended claims, and all changes within the equivalent scope of the present disclosure are embraced by the appended claims.

## Claims

1. A device for controlling a vehicle, the device comprising:
a communication unit which is, based on entry into a charging station, communicably connected to a server disposed in the charging station and receives a digital twin corresponding to the charging station and configured to reflect a real-time situation;
a display unit configured to display the digital twin and receive a user input applied to the digital twin; and
a processor configured to control the display unit to output a first path to a charger capable of performing charging in the charging station and display, on the digital twin, a second path to an exit of the charging station when charging of the vehicle is stopped.

2. The device of claim 1, wherein, when communicably connected to the server, the processor transmits information related to a type of the charger capable of performing charging to the server, receives the first path to the charger capable of performing charging from the server, and outputs the first path onto the digital twin.

3. The device of claim 2, wherein, when a plurality of chargers capable of performing charging are present, the processor displays the plurality of chargers capable of performing charging to be identifiable on the digital twin, and when one of the plurality of chargers is selected, outputs a path to the selected charger onto the digital twin.

4. The device of claim 1, wherein, when a request for controlling driving along the first path is received from the server, the processor transmits a control right to control driving of the vehicle to the server.

5. The device of claim 4, wherein the processor performs autonomous driving along the first path according to control by the server to which the control right is transmitted, and the autonomous driving along the first path is reflected and output onto the digital twin.

6. The device of claim 5, wherein, when an object corresponding to a charger other than the charger corresponding to a destination of the first path is selected through the digital twin, the processor transmits information about the selected other charger to the server, receives and outputs a path to the selected other charger onto the digital twin, and performs autonomous driving along the path to the selected other charger according to control by the server.

7. The device of claim 1, wherein the processor provides a simulation of driving to a location selected by a user through the digital twin.

8. The device of claim 1, wherein the processor provides additional information related to a location in a periphery of the charging station through the digital twin.

9. The device of claim 1, wherein, when the charging of the vehicle is stopped, the processor performs different controls depending on whether a user is present in the vehicle.

10. The device of claim 9, wherein, in such a case that a user is present in the vehicle when the charging of the vehicle is stopped, the processor outputs the second path to the exit of the charging station onto the digital twin, and transmits, to the server, a control right to control driving of the vehicle to perform autonomous driving to the second path according to a request by the user.

11. The device of claim 9, wherein, in such a case that a user is not present in the vehicle when the charging of the vehicle is stopped, the processor receives, from the server, information about a location in which standby is allowed in the charging station and a driving path to the location in which standby is allowed, and when a request for moving is received from a user terminal preauthenticated for the vehicle, transmits a control right to control the vehicle to the server, and moves the vehicle along the driving path to the location in which standby is allowed according to control by the server.

12. The device of claim 1, wherein the processor receives charging information from the server and outputs information about a charging progress situation onto the digital twin.

13. The device of claim 1, wherein the processor receives service information provided by the charging station from the server, outputs the service information through the digital twin, and performs payment for a service selected by a user.
